# DEMANDE DE BREVET EUROPEEN

(11) **EP 1 722 471 A1**
(43) Date de publication de la demande: **15.11.2006**
(21) Numéro de dépôt: 05010229.2
(22) Date de dépôt: 11.05.2005
(51) Int. Cl.: H03C 3/40

(54) **Procédé et dispositif d'élaboration de deux signaux en quadrature de phase, en particulier pour une transposition de fréquence au sein d'un téléphone mobile cellulaire**

(71) Demandeur: STMicroelectronics N.V., 1118 BH Schiphol Airport Amsterdam (NL)
(72) Inventeur: Pozsgay, Andras, 74130 Contamine sur Arve (FR)
(74) Mandataire: Zapalowicz, Francis

(57) **Abrégé**

L'élaboration de deux signaux de sortie (I_{RF}, Q_{RF}) en quadrature de phase ayant un spectre fréquentiel comportant un harmonique prépondérant à une fréquence désirée F_{c}, comprend la génération d'un signal de base périodique (Vₚ) ayant une fréquence F_{osc} égale au produit de R par ladite fréquence désirée F_{c}, R étant un nombre rationnel non entier supérieur à un et égal à un rapport p/q, où p est un entier multiple de 4 et q un entier impair, et un traitement du signal de base comportant par exemple au moins un prétraitement incluant une division fréquentielle par p avec élimination des harmoniques pairs et une multiplication fréquentielle par q.

## Description

L'invention concerne l'élaboration de signaux en quadrature de phase, en particulier des signaux radiofréquence destinés à la transposition de fréquence de signaux en bande de base.

L'invention s'applique avantageusement mais non exclusivement aux téléphones mobiles cellulaires présentant une architecture à conversion directe.

Pour effectuer une conversion montante directe dans une chaîne d'émission radiofréquence, on utilise généralement deux signaux radiofréquence orthogonaux ayant une fréquence égale à la fréquence de sortie désirée. Ces deux signaux orthogonaux de transposition sont multipliés par un signal complexe en bande de base, représentés par deux voies I et Q (voie en phase et voie en quadrature de phase).

Les deux signaux transposés à la fréquence de sortie sont ensuite sommés pour fournir un signal de sortie résultant.

Or, une telle méthode présente des inconvénients majeurs.

En effet, généralement, les deux signaux de transposition résultent d'une division entière de fréquence d'un signal d'oscillateur produit par une boucle à verrouillage de phase, et dont la fréquence est égale à un multiple entier de la fréquence de sortie désirée. Or, comme la fréquence du signal d'oscillateur délivrée par la boucle à verrouillage de phase est égal à K fois la fréquence de sortie désirée, cette fréquence du signal d'oscillateur coïncide avec le Kème harmonique de la fréquence de sortie. Et, en cas de couplage entre les signaux transposés à la fréquence de sortie et le signal d'oscillateur local de la boucle à verrouillage de phase, ce Kème harmonique engendre un phénomène communément désigné par l'homme du métier sous le vocable anglo-saxon de « pulling », qui va dégrader la qualité du signal radiofréquence.

Par ailleurs, lorsque K est égal à 2, une erreur dans le facteur de forme du signal délivré par la boucle à verrouillage de phase provoque une erreur de phase entre les deux signaux de transposition qui ne sont plus orthogonaux. Il en résulte alors une nouvelle dégradation de la qualité du signal radiofréquence après transposition. Ce problème peut être évité en choisissant un facteur K égal à 4, c'est-à-dire en doublant la fréquence de la boucle à verrouillage de phase. Cependant, ceci conduit à une augmentation de consommation.

Ce problème de « pulling » peut s'avérer tellement crucial, en particulier dans les dispositifs monopuce, que la conversion directe est alors remplacée par une conversion hétérodyne, résolvant le problème de « pulling » mais conduisant à des architectures beaucoup plus complexes.

L'invention vise à apporter une solution à ce problème.

Un but de l'invention est d'éliminer le problème de « pulling » provenant de la fréquence de l'oscillateur dans toute chaîne de conversion directe.

L'invention a encore pour but d'éliminer les causes possibles de pulling autres que celles provenant directement de la boucle à verrouillage de phase.

Selon un aspect de l'invention, il est par conséquent proposé un procédé d'élaboration de deux signaux de sortie en quadrature phase ayant un spectre fréquentiel comportant un harmonique prépondérant à une fréquence désirée F_{c}. Ce procédé comprend la génération d'un signal de base périodique ayant une fréquence F_{osc} égal au produit de R par ladite fréquence désirée F_{c}, R étant un nombre rationnel non entier supérieur à 1 et égal à un rapport p/q, où p est un entier multiple de 4 et q un entier impair.

Le procédé comprend également une réception de deux signaux initiaux en bande de base en quadrature de phase.

Le procédé comprend également au moins une phase de division fréquentielle par p du signal de base, une phase de multiplication fréquentielle par q, une phase d'élimination d'harmoniques pairs, et une transposition de fréquence des deux signaux initiaux avec des signaux de transposition issus de l'une de ces phases et ayant un spectre fréquentiel comportant un harmonique prépondérant à ladite fréquence désirée F_{c}.

Il convient de noter que puisque le traitement comporte une transposition de fréquence de deux signaux initiaux, le spectre fréquentiel des signaux de sortie comporte un harmonique prépondérant dont la fréquence est égale à la fréquence désirée F_{c} + ou ― la fréquence des signaux initiaux, c'est-à-dire de sensiblement à la fréquence désirée puisque ces signaux initiaux sont des signaux en bande de base, c'est à dire que leur spectre fréquentiel est centré autour de 0 Hz.

En d'autres termes, cet aspect de l'invention est basé sur une division rationnelle non entière du signal de base, par exemple issu d'une boucle à verrouillage de phase. Il n'y a alors aucun harmonique des signaux de sortie qui coïncide avec la fréquence F_{osc}. Par ailleurs, le fait de choisir p multiple de 4 permet de générer des signaux de sortie en quadrature. En outre, le fait de choisir q impair et le fait d'éliminer les harmoniques pairs permet d'obtenir seulement des harmoniques impairs de F_{osc}/p, et par conséquent de n'avoir aucun harmonique coïncidant avec la fréquence F_{osc}, supprimant ainsi toute source de pulling.

Dans sa généralité, et selon cet aspect de l'invention, l'ordre dans lequel on effectue les différentes phases du traitement ainsi que la transposition de fréquence est indifférent. Ainsi en particulier on peut effectuer indifféremment d'abord la division fréquentielle par p puis la multiplication fréquentielle par q ou bien l'inverse. De même on peut effectuer d'abord une transposition de fréquence puis une élimination des harmoniques pairs ou bien l'inverse.

Ainsi, à titre indicatif, il serait tout à fait envisageable d'effectuer tout d'abord une multiplication fréquentielle par q du signal de base, par exemple en utilisant des boucles classiques à verrouillage de retard ( « Delay Locked Loop » : DLL, selon une dénomination bien connue de l'homme du métier), puis d'effectuer une division fréquentielle par p générant également directement les deux signaux en quadrature, et ce en utilisant un diviseur fréquentiel de structure classique et connue en soi.

Cela étant, une telle solution peut s'avérer plus complexe à mettre en oeuvre, compte tenu des valeurs élevées de fréquence, dans certaines technologies.

Aussi, est-il préférable d'effectuer d'abord une division fréquentielle par p, puis une multiplication fréquentielle par q.

Ainsi selon une variante de mise en oeuvre de l'invention, le traitement comprend la phase de division fréquentielle par p, la phase de multiplication fréquentielle par q, la phase d'élimination des harmoniques pairs des signaux issus de la multiplication fréquentielle, et la transposition de fréquence avec des signaux de transposition issus de la phase d'élimination et ne comportant que des harmoniques impairs.

Selon une autre variante possible de mise en oeuvre, le traitement comprend la phase de division fréquentielle par p, la phase de multiplication fréquentielle par q, la transposition de fréquence avec des signaux de transposition issus de la phase de multiplication fréquentielle, et l'élimination des harmoniques pairs des signaux transposés.

Dans l'une ou l'autre de ces variantes, la phase de division fréquentielle et la phase de multiplication fréquentielle comportent avantageusement des opérations communes effectuées en même temps et incluant des combinaisons logiques de signaux et q-1 décalages de signaux par des multiples de la période ou de la demi période du signal de base, chaque multiple de ladite période ou de ladite demi période étant égal au produit de ladite période ou de ladite demi période par un coefficient entier pris dans le groupe des entiers les plus proches de R ou de 2R, respectivement.

La phase de division fréquentielle peut comporter une succession de divisions fréquentielles par 2 ou plus généralement si p n'est pas un multiple de 2, un comptage modulo p du signal de base de façon à générer une succession de signaux primaires, et lesdites opérations communes comportent des combinaisons logiques de ces signaux primaires entre eux et éventuellement avec le signal de base.

Selon un autre mode de mise en oeuvre, les opérations communes effectuées en même temps dans la phase de division fréquentielle et dans la phase de multiplication fréquentielle peuvent inclure la division fréquentielle par p et lesdits q-1 décalages de signaux par des multiples de la période ou de la demi période du signal de base, en particulier lorsqu'on utilise un compteur en anneau du type compteur Johnson.

La phase de multiplication comporte en outre de préférence une sommation de signaux effectuée après la phase de décalage de façon à délivrer deux paires de signaux périodiques tertiaires ayant chacun la fréquence F_{c}.

Selon un mode de mise en oeuvre de l'invention lesdites opérations communes comportent une génération de deux paires de groupes de q signaux ayant chacun une fréquence Fₛ égale à F_{c}/q, chaque groupe comportant un signal périodique secondaire et les q-1 signaux décalés par rapport à ce signal périodique secondaire par lesdits multiples de la période ou de la demi période du signal de base, les q signaux d'un groupe de chaque paire étant respectivement en opposition de phase par rapport aux q signaux homologues de l'autre groupe de ladite paire, et en quadrature de phase par rapport aux q signaux du groupe homologue de l'autre paire.

La phase d'élimination des harmoniques pairs comporte par exemple deux soustractions de signaux de façon à délivrer une paire de signaux.

Il peut exister également une source additionnelle de pulling qui réside dans le fait que des harmoniques pairs peuvent être générés à différents étages de la chaîne d'émission en raison de la génération d'une somme parasite due à la propagation de courant injecté dans l'alimentation ou dans la masse.

L'invention résout également ce problème additionnel par exemple en choisissant de façon appropriée la largeur des impulsions des signaux de sortie à la fréquence F_{c}.

Plus précisément on peut doubler la largeur des impulsions.

En d'autres termes, selon un mode de mise en oeuvre de l'invention la phase de division fréquentielle comporte la délivrance de signaux ayant des impulsions de largeur égale au double de la demi-période ou de la période du signal de base. L'utilisation d'un compteur Johnson par exemple permet d'obtenir de façon simple ce doublement de la largeur des impulsions.

Selon une autre variante de l'invention ledit traitement comprend une phase de division fréquentielle par p avec élimination des harmoniques pairs de façon à générer deux signaux intermédiaires périodiques en quadrature de phase ayant chacun une fréquence Fₛ égale à F_{c}/q et des harmoniques de fréquences impairs, une phase de multiplication fréquentielle par q des deux signaux intermédiaires, et la transposition de fréquence avec des signaux de transposition issus de la phase de multiplication et ne comportant que des harmoniques impairs

Selon un mode de mise en oeuvre, parfaitement compatible avec une technologie numérique, par exemple une technologie CMOS à base de portes logiques, la phase de division fréquentielle par p avec élimination des harmoniques pairs comprend :
- des divisions successives par 2 ou un comptage modulo p du signal de base de façon à générer des signaux primaires,
- des combinaisons logiques de ces signaux primaires entre eux et éventuellement avec le signal de base de façon à générer deux paires de signaux périodiques secondaires ayant chacun la fréquence Fₛ (égale à F_{c}/q), les deux signaux secondaires de chaque paire étant en quadrature de phase et les deux paires étant également elles-mêmes en quadrature de phase, et
- des soustractions de ces signaux secondaires de façon à générer les deux signaux intermédiaires.

Bien qu'il soit possible d'effectuer la multiplication par q en utilisant des circuits classiques et connus en soi de boucle à verrouillage de retard, il est particulièrement avantageux, toujours dans l'optique de l'utilisation d'une technologie numérique CMOS, d'utiliser des circuits de retard ainsi que des additionneurs pour effectuer cette multiplication.

Plus précisément, selon un mode de mise en oeuvre préféré de l'invention, dans lequel la paire de signaux intermédiaires ayant chacun la fréquence Fₛ, comporte un premier signal intermédiaire et un deuxième signal intermédiaire en quadrature de phase par rapport au premier, la phase de multiplication fréquentielle par q comporte :
q-1 décalages successifs de la paire de signaux intermédiaires par des multiples de la période ou de la demi période du signal de base de façon à obtenir q-1 paires de signaux décalés, chaque paire de signaux décalés comportant un premier signal décalé et un deuxième signal décalé en quadrature de phase par rapport au premier, chaque multiple de ladite période ou de ladite demi période étant égal au produit de ladite période ou de ladite demi période par un coefficient entier pris dans le groupe des entiers les plus proches de R ou de 2R, respectivement,
la somme du premier signal intermédiaire et des q-1 premiers signes décalés, et
la somme du deuxième signal intermédiaire et des q-1 deuxièmes signes décalés.

On peut effectuer la transposition de fréquence avec les signaux directement issus de la multiplication.

En variante on peut choisir de façon appropriée la largeur des impulsions des signaux de transposition à la fréquence F_{c} avant d'effectuer la transposition de fréquence, et résoudre ainsi le problème de source additionnelle de pulling.

Plus précisément, selon un mode de mise en oeuvre avantageux de l'invention, la phase de multiplication fréquentielle délivre un premier signal prétraité et un deuxième signal prétraité en quadrature de phase par rapport au premier signal prétraité, et ledit traitement comporte en outre un post-traitement des deux signaux prétraités, ce post-traitement comportant :
- un décalage de ces deux signaux prétraités de la période ou de la demi période du signal de base de façon à obtenir un premier signal prétraité décalé et un deuxième signal prétraité décalé en quadrature de phase par rapport au premier signal prétraité décalé,
- la somme du premier signal prétraité et du premier signal prétraité décalé, et
- la somme du deuxième signal prétraité et du deuxième signal prétraité décalé,
de façon à obtenir les deux signaux de transposition.

Il est par ailleurs particulièrement avantageux de choisir q égal à 3. En effet, il a été observé qu'un tel choix de valeurs permettait d'éloigner le plus possible les harmoniques gênants.

Selon un autre aspect de l'invention, il est également proposé un dispositif d'élaboration de deux signaux de sortie en quadrature de phase ayant un spectre fréquentiel comportant un harmonique prépondérant à une fréquence désirée F_{c}, ledit dispositif comprenant
- des moyens de génération aptes à générer un signal de base périodique ayant une fréquence F_{osc} égale au produit de R par ladite fréquence désirée F_{c}, R étant un nombre rationnel non entier supérieur à un et égal à un rapport p/q, où p est un entier multiple de 4 et q un entier impair,
- une interface d'entrée pour recevoir deux signaux initiaux en bande de base en quadrature de phase, et
- des moyens de traitement connectés aux moyens de génération et à ladite interface d'entrée et aptes à effectuer un traitement comportant au moins une phase de division fréquentielle par p du signal, de base, une phase de multiplication fréquentielle par q, une phase d'élimination des harmoniques pairs, et une transposition de fréquence des deux signaux initiaux avec des signaux de transposition issus de l'une de ces phases et ayant un spectre fréquentiel comportant un harmonique prépondérant à ladite fréquence désirée F_{c}.

Selon une variante de l'invention, les moyens de traitement incluent un premier sous-étage possédant une entrée pour recevoir le signal de base et apte à effectuer la phase de division fréquentielle par p, un deuxième sous-étage apte à effectuer la phase de multiplication fréquentielle par q, un troisième sous-étage apte à effectuer la phase d'élimination des harmoniques pairs des signaux issus du deuxième sous-étage, et des moyens de transposition de fréquence connectés à ladite interface d'entrée et à la sortie du troisième sous-étage et aptes à délivrer les deux signaux de sortie.

Le troisième sous-étage est alors par exemple apte à effectuer des soustractions des signaux délivrés par le deuxième sous-étage.

Selon une autre variante de l'invention, les moyens de traitement incluent un premier sous-étage apte à effectuer la phase de division fréquentielle par p, un deuxième sous-étage apte à effectuer la phase de multiplication fréquentielle par q, des moyens de transposition de fréquence connectés à ladite interface d'entrée et à la sortie du deuxième sous-étage, et un troisième sous-étage apte à effectuer la phase d'élimination des harmoniques pairs des signaux issus des moyens de transposition de façon à délivrer les deux signaux de sortie.

Le troisième sous-étage est alors avantageusement apte à effectuer des soustractions des signaux délivrés par les moyens de transposition de fréquence de façon à générer les deux signaux de sortie.

Dans l'une ou l'autre de ces variantes, le premier sous-étage et le deuxième sous-étage comportent avantageusement des moyens logiques communs aptes à effectuer à la fois des combinaisons logiques de signaux et q-1 décalages de signaux par des multiples de la période ou de la demi période du signal de base, chaque multiple de ladite période ou de ladite demi période étant égal au produit de ladite période ou de ladite demi période par un coefficient entier pris dans le groupe des entiers les plus proches de R ou de 2R, respectivement.

Selon un mode de réalisation le premier sous-étage comporte une succession de diviseurs fréquentiels par 2 ou un compteur modulo p, possédant une entrée pour recevoir le signal de base et des sorties aptes à générer une succession de signaux primaires aux moyens logiques communs, et les moyens logiques communs sont aptes à effectuer des combinaisons logiques de ces signaux primaires entre eux et éventuellement avec le signal de base.

Les moyens logiques communs comportent par exemple des portes logiques ET avec certaines de leurs entrées inverseuses.

Selon un autre mode de réalisation, le premier sous-étage et le deuxième sous-étage comportent des moyens logiques communs aptes à effectuer à la fois la division fréquentielle par p et q-1 décalages de signaux par des multiples de la période ou de la demi période du signal de base, chaque multiple de ladite période ou de ladite demi période étant égal au produit de ladite période ou de ladite demi période par un coefficient entier pris dans le groupe des entiers les plus proches de R ou de 2R, respectivement.

Les moyens logiques communs comportent alors par exemple un compteur en anneau à p étages possédant une entrée pour recevoir le signal de base.

Selon un mode de réalisation, le deuxième sous-étage comporte des moyens de sommation connectés à la sortie des moyens logiques communs et aptes à délivrer deux paires de signaux périodiques tertiaires ayant chacun la fréquence F_{c}.

Les moyens de sommation comportent par exemple deux paires de portes logiques OU connectées aux sorties des moyens logiques communs.

Selon un mode de réalisation, les moyens logiques communs sont aptes à générer deux paires de groupes de q signaux ayant chacun une fréquence Fₛ égale à F_{c}/q, chaque groupe comportant un signal périodique secondaire et les q-1 signaux décalés par rapport à ce signal périodique secondaire par lesdits multiples de la période ou de la demi période du signal de base, les q signaux d'un groupe de chaque paire étant respectivement en opposition de phase par rapport aux q signaux homologues de l'autre groupe de ladite paire, et en quadrature de phase par rapport aux q signaux du groupe homologue de l'autre paire.

Les moyens logiques communs comportent alors par exemple deux paires de groupes de q portes logiques ET avec certaines de leurs entrées inverseuses et sont aptes à générer les deux paires de groupes de q signaux, et les moyens de sommation comportent par exemple deux paires de portes logiques OU respectivement connectées aux deux paires de groupes de q portes logiques ET.

Le troisième sous-étage comporte alors par exemple deux soustracteurs respectivement connectés aux deux paires de portes OU.

De façon à résoudre le problème de la source additionnelle de pulling, le premier étage comporte de préférence des moyens aptes à délivrer des signaux ayant des impulsions de largeur égale au double de la demi-période ou de la période du signal de base.

De tels moyens aptes à délivrer des signaux ayant des impulsions de largeur égale au double de la demi-période ou de la période du signal de base sont avantageusement constitués du compteur en anneau à p étages.

Selon une autre variante de l'invention, les moyens de traitement comportent un étage de prétraitement incluant un premier bloc apte à effectuer une division fréquentielle par p avec élimination des harmoniques pairs,un deuxième bloc apte à effectuer une multiplication fréquentielle par q et des moyens de transposition de fréquence connectés à la sortie de l'étage de prétraitement et à ladite interface d'entrée..

Selon un mode de mise en oeuvre de l'invention, le premier bloc est apte à recevoir le signal de base et à délivrer deux signaux intermédiaires périodiques en quadrature de phase ayant chacun une fréquence Fₛ égale à F_{c}/q et des harmoniques de fréquences impairs, et le deuxième bloc est apte à effectuer une multiplication fréquentielle par q des deux signaux intermédiaires.

Selon un mode de mise en oeuvre de l'invention, le premier bloc comprend
- une succession de diviseurs fréquentiels par 2 ou un compteur modulo p possédant une entrée pour recevoir le signal de base et des sorties aptes à générer une succession de signaux primaires,
- une logique apte à effectuer des combinaisons logiques de ces signaux primaires entre eux et éventuellement avec le signal de base de façon à générer deux paires de signaux périodiques secondaires ayant chacun la fréquence Fₛ , les deux signaux secondaires de chaque paire étant en quadrature de phase et les deux paires étant également elles même en quadrature de phase, et
- des moyens de soustraction aptes à effectuer des soustractions de ces signaux secondaires de façon à générer les deux signaux intermédiaires.

Selon un mode de mise en oeuvre de l'invention, dans lequel la paire de signaux intermédiaires comporte un premier signal intermédiaire et un deuxième signal intermédiaire en quadrature de phase par rapport au premier, le deuxième bloc comporte :
- des moyens de décalage aptes à effectuer q-1 décalages successifs de la paire de signaux intermédiaires par des multiples de la période ou de la demi période du signal de base de façon à obtenir q-1 paires de signaux décalés, chaque paire de signaux décalés comportant un premier signal décalé et un deuxième signal décalé en quadrature de phase par rapport au premier, chaque multiple de ladite période ou de ladite demi période étant égal au produit de ladite période ou de ladite demi période par un coefficient entier pris dans le groupe des entiers les plus proches de R ou de 2R, respectivement,
- un additionneur apte à effectuer la somme du premier signal intermédiaire et des q-1 premiers signaux décalés, et
- un additionneur apte à effectuer la somme du deuxième signal intermédiaire et des q-1 deuxièmes signaux décalés.

Selon un mode de mise en oeuvre de l'invention dans lequel l'étage de prétraitement du signal de base est apte à délivrer un premier signal prétraité et un deuxième signal prétraité en quadrature de phase par rapport au premier signal prétraité, les moyens de traitement comportent en outre un étage de post-traitement des deux signaux prétraités connecté entre la sortie de l'étage de pré-traitement et les moyens de transposition de fréquence et comportant
- un moyen supplémentaire de décalage apte à effectuer un décalage de ces deux signaux prétraités de la période ou de la demi période du signal de base de façon à obtenir un premier signal prétraité décalé et un deuxième signal prétraité décalé en quadrature de phase par rapport au premier signal prétraité décalé,
- un additionneur apte à effectuer la somme du premier signal prétraité et du premier signal prétraité décalé et
- un additionneur apte à effectuer la somme du deuxième signal prétraité et du deuxième signal prétraité décalé, de façon à obtenir les deux signaux de transposition.

Selon un autre aspect de l'invention, il est également proposé un terminal d'un système de communication sans fil, par exemple un téléphone mobile cellulaire, incorporant un dispositif tel que défini ci-avant.

D'autres avantages et caractéristiques de l'invention apparaîtront à l'examen de la description détaillée de modes de réalisation et de mise en oeuvre, nullement limitatifs, et des dessins annexés, sur lesquels :
- la figure 1 illustre de façon schématique un mode de réalisation d'un téléphone mobile cellulaire incorporant un mode de réalisation d'un dispositif selon l'invention,
- la figure 2 illustre plus en détail mais toujours de façon schématique une partie d'un mode de réalisation d'un dispositif selon l'invention,
- la figure 3 illustre plus en détail mais toujours de façon schématique une autre partie d'un mode de réalisation d'un dispositif selon l'invention,
- les figures 4 à 7 illustrent schématiquement un mode de mise en oeuvre d'un procédé selon l'invention ainsi que certains résultats obtenus,
- les figures 8 et 9 illustrent schématiquement un autre exemple de mise en oeuvre de l'invention,
- les figures 10 et 11 illustrent schématiquement et respectivement un autre mode de réalisation d'un dispositif selon l'invention permettant un autre mode de mise en oeuvre de l'invention,

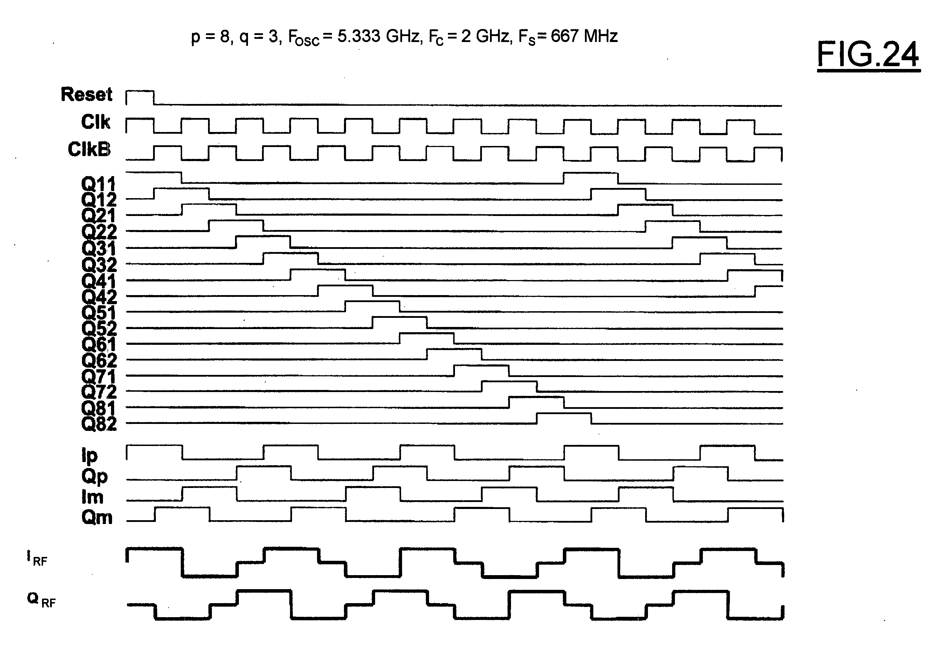

- les figures 12 à 24 illustrent encore d'autres modes de réalisation et de mise en oeuvre de l'invention.

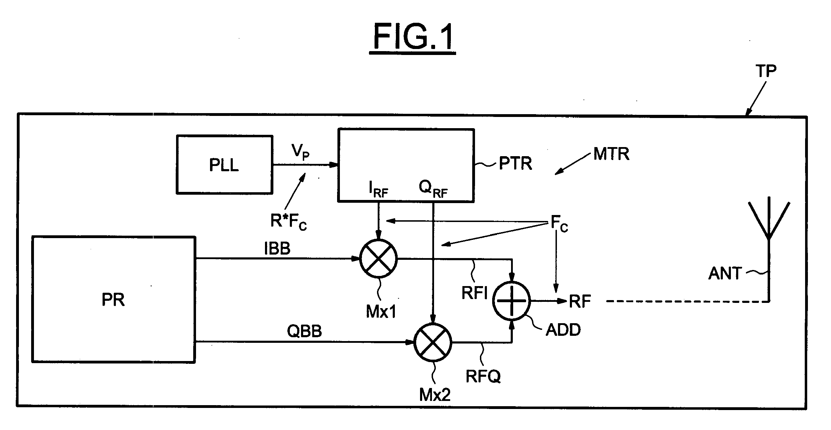

Sur la figure 1, la référence TP désigne un téléphone mobile cellulaire faisant partie d'un système de communication sans fil, par exemple un système GSM, ou bien CDMA, bien que l'invention ne soit pas limitée à ce type de système.

Le téléphone TP comporte de façon classique une chaîne d'émission comprenant de façon classique et connue en soi un processeur PR effectuant les traitements en bande de base et délivrant deux signaux initiaux en bande de base IBB et QBB, ces deux signaux étant en quadrature de phase. Selon une dénomination habituellement utilisée par l'homme du métier, le signal IBB est appelé signal « en phase » tandis que le signal QBB est appelé signal « en quadrature de phase ».

L'architecture décrit ici est une architecture à conversion directe, c'est-à-dire que les deux signaux en bande de base IBB et QBB sont directement transposés à la fréquence radiofréquence désirée F_{c}, au sein de moyens de transposition de fréquence formés ici de deux mélangeurs MX1 et MX2.

Ces deux mélangeurs reçoivent respectivement deux signaux de transposition I_{RF} et Q_{RF}, mutuellement en quadrature de phase, et ayant comme on le verra ci-après un harmonique prépondérant à la fréquence de transposition F_{c}.

Les deux signaux transposés ou signaux de sortie RFI et RFQ sont ensuite sommés dans un additionneur ADD pour fournir un signal résultant RF qui sera, après divers traitements classiques, transmis via l'antenne ANT du téléphone.

Le dispositif d'élaboration des deux signaux de transposition, également désignés « signaux de sortie du dispositif d'élaboration », I_{RF} et Q_{RF} comporte des moyens PLL de génération d'un signal de base périodique V_{P}, ayant une fréquence F_{osc} égale au produit de la fréquence F_{c} par un nombre rationnel non entier R, ainsi que des moyens de traitement MTR qui incorporent ici un étage de pré traitement PTR ainsi que les moyens de transposition de fréquence MX1 et MX2.

Les moyens de génération du signal de base V_{P} p sont par exemple réalisés par une boucle à verrouillage de phase PLL de structure classique et comportant un oscillateur commandé en tension et délivrant le signal de base V_{P}.

Le nombre rationnel R est égal au rapport de p/q de deux entiers p et q, p étant choisi multiple de 4 et q étant choisi impair. Par ailleurs, p est choisi supérieur à q et non multiple de q de sorte que le nombre rationnel R est un nombre supérieur à 1 et non entier.

A titre d'exemple, pour une fréquence F_{c} égale à 2 GHz, on pourra choisir p égal à 16 et q égal à 3, ce qui conduit par conséquent à une fréquence F_{osc} du signal de base Vₚ égale à 10, 667 GHz.

Pour une même fréquence F_{c} égale à 2 GHz, les choix de p et de q respectivement égaux à 8 et 3 conduit à une fréquence du signal de base F_{osc} égale à 5,333 GHz.

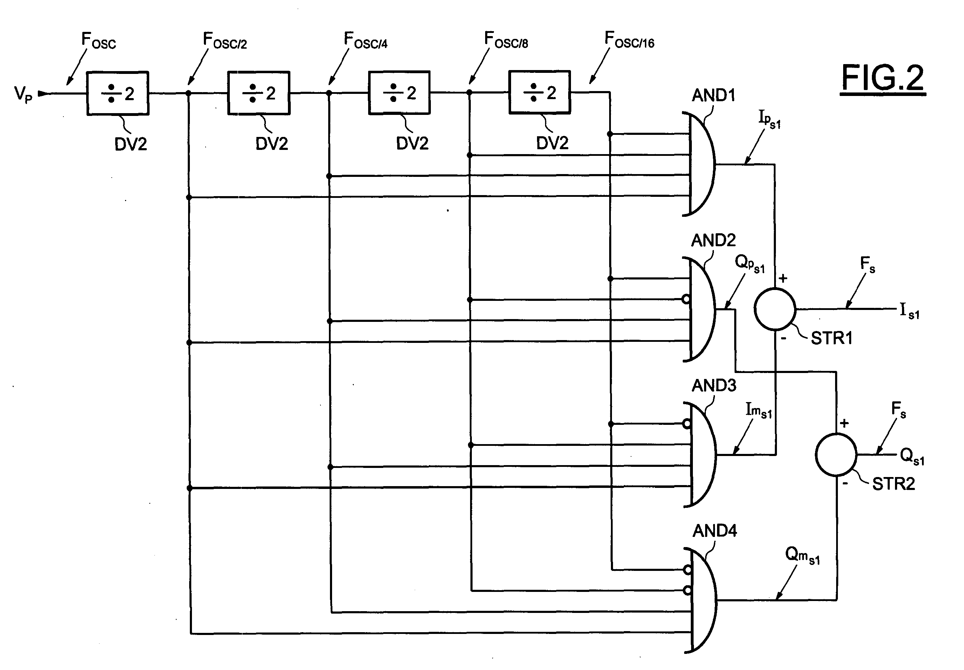

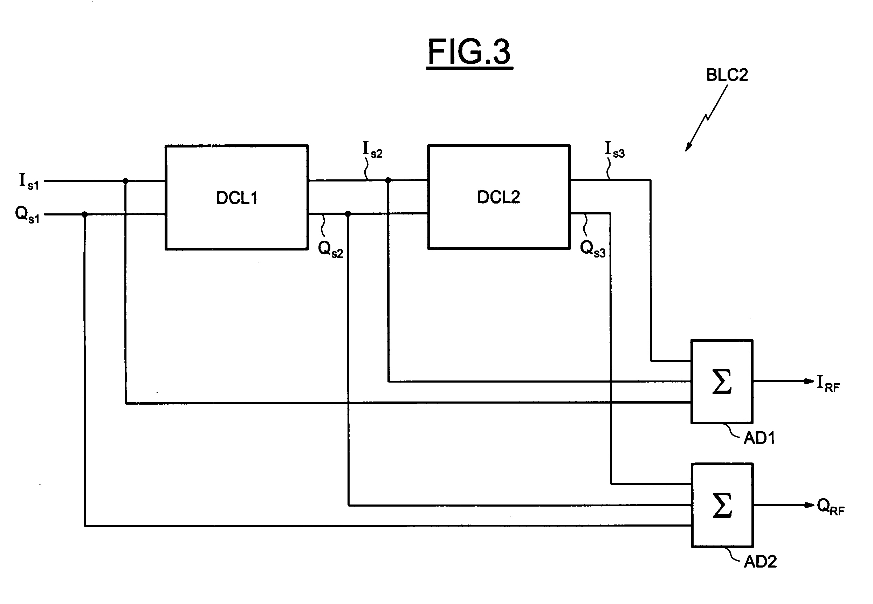

On va maintenant décrire en se référant plus particulièrement aux figures 2 et 3 un exemple de structure des moyens de traitement MTR, aisément compatible avec une technologie CMOS numérique.

Plus précisément, les moyens de traitement MTR comportent au moins l'étage de prétraitement incluant un premier bloc BLC1, dont un exemple de réalisation est illustré sur la figure 2, et un deuxième bloc BLC2 dont un exemple de réalisation est illustré sur la figure 3.

Le premier bloc BLC1 est apte à effectuer une division fréquentielle par p du signal de base Vₚ avec élimination des harmoniques pairs.

Comme illustré sur la figure 2, ce bloc BLC1 reçoit le signal de base Vₚ ayant la fréquence F_{osc} et délivre deux signaux intermédiaires périodiques I_{S1} et Q_{S1}, ces deux signaux étant en quadrature de phase et ayant chacun une fréquence Fₛ égale à F_{c}/q et des harmoniques de fréquence impairs.

Pour réaliser cette opération, le premier bloc BLC1 comprend dans l'exemple décrit une succession de diviseurs par 2, référencés DV2, aptes à effectuer une succession de divisions du signal de base de façon à générer une succession de signaux primaires.

Dans l'exemple décrit ici, avec p = 16, on utilise quatre diviseurs par 2 délivrant respectivement quatre signaux primaires périodiques ayant respectivement les fréquences F_{osc}/2, F_{osc}/4, F_{osc}/8 et F_{osc}/16.

Le bloc BLC1 comporte par ailleurs une logique formée ici dé quatre portes logiques ET référencées ANDI-AND4 dont certaines entrées de certaines portes sont inversées.

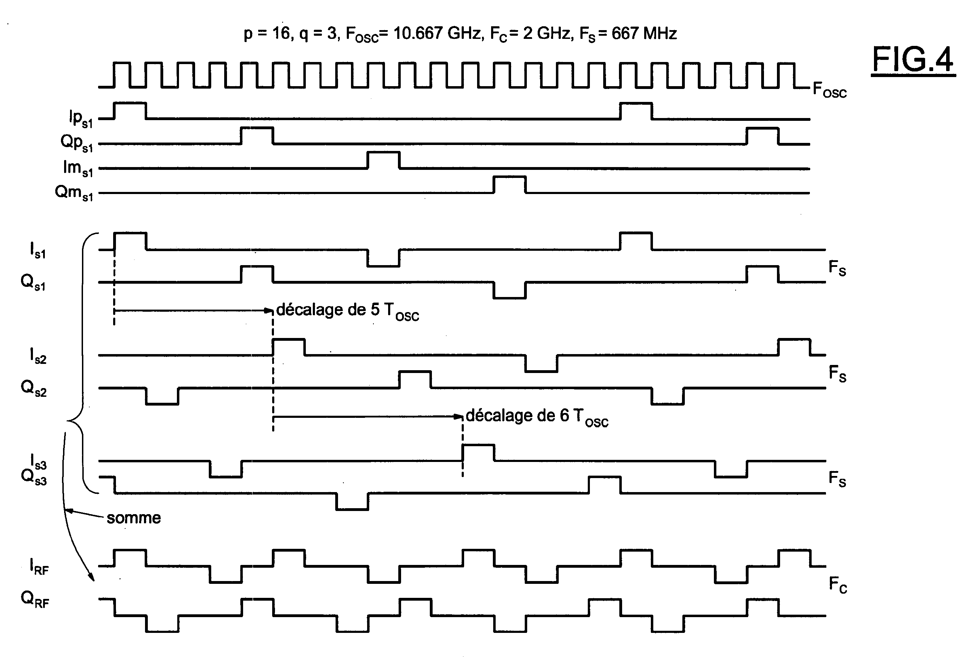

De ce fait, si l'on se réfère maintenant plus particulièrement à la figure 4, on voit que la porte logique AND1 délivre en sortie le signal périodique secondaire Ip_{S1}.

La porte logique AND2, ayant sa deuxième entrée inversée, délivre le signal périodique secondaire Qp_{S1}.

La porte logique AND3, ayant sa première entrée inversée, délivre le signal périodique secondaire Im_{S1} et la porte logique AND4, ayant ses deux première entrées inversées, délivre le signal périodique secondaire Qm_{S1}.

Chacun de ces signaux périodiques secondaires est périodique de période Tₛ et a une fréquence Fₛ égale à F_{c}/q, égale dans le cas présent à 667 MHz puisque q est égal à 3.

Une première paire de ces signaux périodiques secondaires est formée des signaux Ip_{S1} et Qp_{S1} et la deuxième paire de ces signaux secondaires est formée des signaux Im_{S1} et Qm_{S1}.

Les deux signaux secondaires de chaque paire sont en quadrature de phase et les deux paires sont également elles-mêmes en quadrature de phase.

On voit sur cet exemple que l'on a par conséquent effectué une combinaison logique des sorties des quatre diviseurs DV2.

Le bloc BLC1 comporte par ailleurs des moyens de soustraction STR1 et STR2 aptes à effectuer des soustractions de ces signaux secondaires de façon à générer les deux signaux intermédiaires I_{S1} et Q_{S1}.

Plus précisément, le soustracteur STR1 est relié à la sortie des portes logiques AND1 et AND3 tandis que le soustracteur STR2 est relié à la sortie des portes logiques AND2 et AND4.

On voit donc sur la figure 4 que les signaux intermédiaires I_{S1} et Q_{S1} sont des signaux périodiques de fréquence Fₛ (période Ts) et ne comportent que des harmoniques de fréquence impairs.

Ces deux signaux intermédiaires I_{S1} et Q_{S1} sont par ailleurs en quadrature de phase l'un par rapport à l'autre.

Le bloc BLC2 dont un exemple de réalisation est illustré sur la figure 3, va effectuer une multiplication fréquentielle par q des deux signaux intermédiaires I_{S1} et Q_{S1}.

Dans ce mode de réalisation, le bloc BLC2 comporte des moyens de décalage DLC1 et DLC2 aptes à effectuer q-1 (ici deux), décalages successifs de la paire de signaux intermédiaires I_{S1} et Q_{S1} par des multiples de la période T_{osc} du signal de base de façon à obtenir q-1 paires de signaux décalés.

Matériellement, les deux circuits de décalage DCL1 et DCL2 sont par exemple réalisés avec des moyens de retard cadencés par le signal de base Vₚ ayant comme période T_{osc}.

Par ailleurs, chaque multiple de la période du signal de base est égal au produit de ladite période par un coefficient entier pris dans le groupe des entiers les plus proches de R.

Dans le cas présent, R est égal à 16/3. En conséquence, les entiers les plus proches de R sont 5 et 6.

Aussi, à titre d'exemple, et comme illustré sur la figure 4, les signaux I_{S1} et Q_{S1} sont respectivement décalés de 5 fois la période T_{osc} de façon à donner deux signaux décalés I_{S2} et Q_{S2.}

En outre, le signal I_{S2} et le signal Q_{S2} sont eux-mêmes à leur tour décalés par exemple de 6 fois la période T_{osc} de façon à fournir deux signaux décalés I_{S3} et Q_{S3}.

Les trois signaux mutuellement décalés, I_{S1}, I_{S2} et l_{S3} sont sommés dans un premier additionneur AD1 de façon à délivrer le signal de sortie en phase I_{RF} (signal de transposition en phase).

De même, les trois signaux décalés, mais cette fois-ci en quadrature de phase, Q_{S1}, Q_{S2} et Q_{S3} sont sommés dans un deuxième additionneur AD2 de façon à former le signal de transposition Q_{RF} en quadrature de phase par rapport au signal I_{RF}.

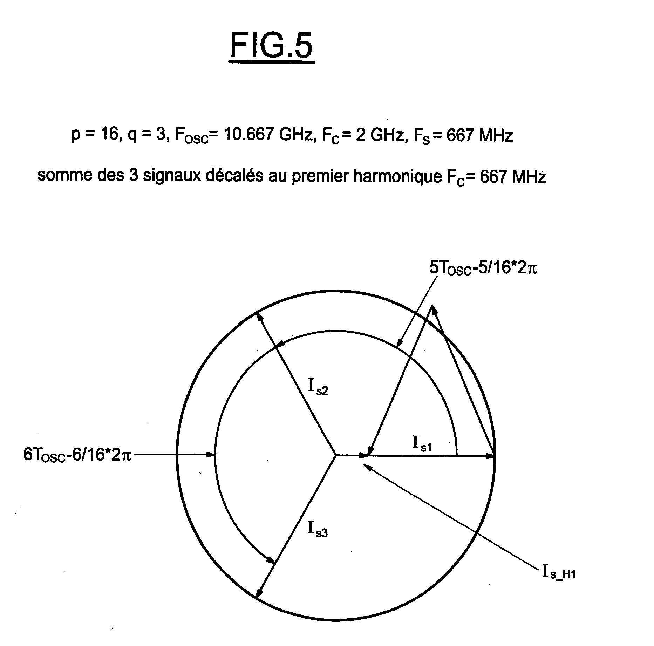

On voit sur la figure 5 que la somme des décalages entre le signal I_{S1} et I_{S2}, entre le signal I_{S2} et I_{S3}, et entre le signal I_{S3} et I_{S1} est égal à p (16, en l'espèce).

Les signaux de transposition obtenus I_{RF} et Q_{RF} sont en l'espèce des signaux périodiques de période qT_{c}. Ils présentent, comme illustré sur la figure 5, un harmonique principal (ou harmonique de rang 1) I_{S-H1} (de fréquence Fc/q) faible.

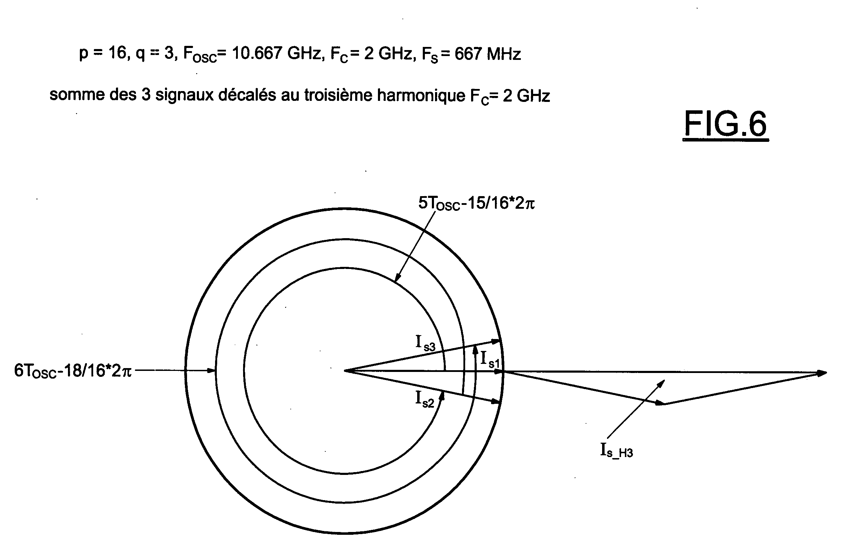

Par ailleurs, les harmoniques pairs sont nuls et ces signaux ne comportent que des harmoniques impairs avec l'harmonique de rang q renforcé ou prépondérant. Cet harmonique de rang q, en l'espèce de rang 3, a la fréquence F_{c}. Et, on voit sur la figure 6 que cet harmonique I_{S-H3} est effectivement prépondérant.

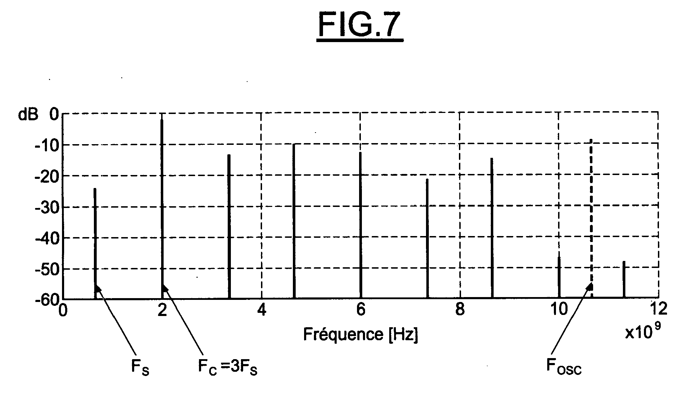

Dans le cas d'espèce, on voit, comme illustré sur la figure 7, que l'harmonique de rang 3, correspondant à la fréquence F_{c} de 2 GHZ, est renforcé tandis que l'harmonique de rang 1 ayant la fréquence Fₛ est considérablement amoindri. Par ailleurs, la fréquence F_{osc} du signal de base est placée entre deux harmoniques élevés de Fₛ, en l'espèce entre les harmoniques de rang 15 et de rang 17.

Il n'y a donc pas de source de pulling.

Il convient de noter ici que les harmoniques autres que l'harmonique de rang « q » pourront être aisément supprimés par filtrage.

Par ailleurs, dans l'exemple de réalisation qui vient d'être décrit, la fréquence de transposition F_{c} est obtenue au niveau d'un harmonique de rang q différent de l'harmonique principal ou de rang 1. Cela étant, si l'on avait adopté d'autres modes de réalisation pour la division fréquentielle par p et la multiplication fréquentielle par q, par exemple en utilisant des boucles à verrouillage de retard, on aurait obtenu effectivement des signaux de transposition ayant un harmonique de rang principal égal à F_{c}.

La figure 7 illustre un autre exemple de réalisation et de mise en oeuvre dans lequel p est égal à 8 et q est égal à 3.

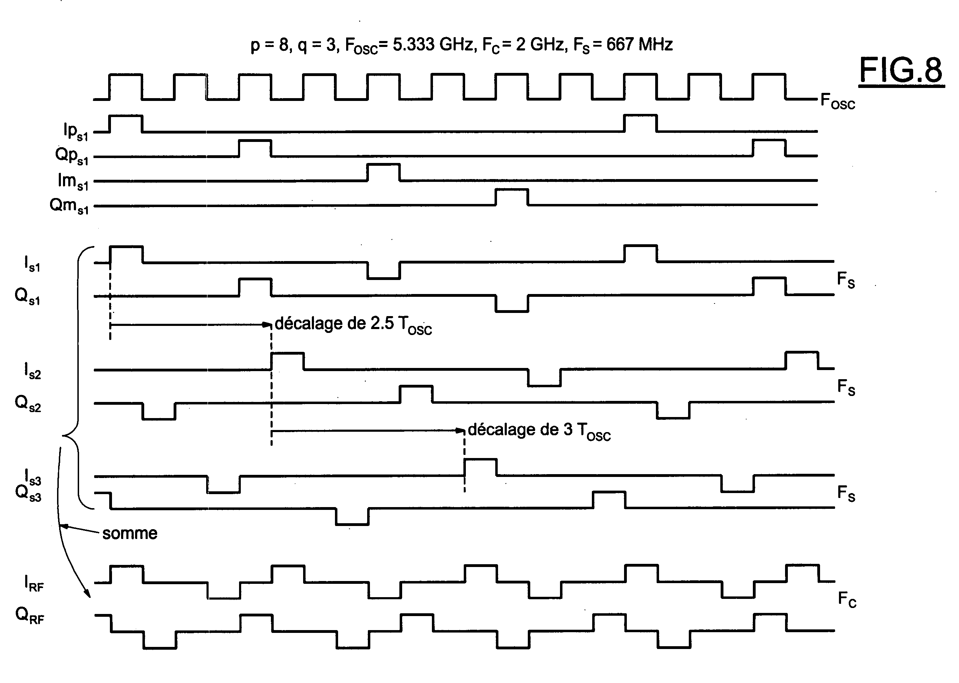

Par ailleurs, alors que dans l'exemple illustré sur les figures 2 à 7, on avait utilisé uniquement les fronts montants du signal de base V_{P} (fréquence Fₒₛₑ) et par conséquent uniquement les sorties des diviseurs DV2, on utilise dans l'exemple de la figure 8, à la fois les fronts montants et les fronts descendants du signal de base. De ce fait, la logique du bloc BLC1 permettant d'obtenir les signaux Ip_{S1,} Qp_{S1,} Im_{S1} et Qm_{S1} utilise également une combinaison logique de la sortie des diviseurs et du signal de base.

Par ailleurs, dans ce cas, on peut également effectuer un décalage égal à un multiple entier de la demi période T_{osc} du signal de base.

Ainsi, dans le cas présent illustré sur la figure 8, et puisque R est égal à 8/3, les deux entiers les plus proches de 2R sont 5 et 6.

On choisira par conséquent par exemple de décaler les signaux Iₛ₂ et Qₛ₂ de cinq fois la demi période du signal de base et de décaler les signaux Iₛ₃ et Qₛ₃ de six fois la demi période du signal de base.

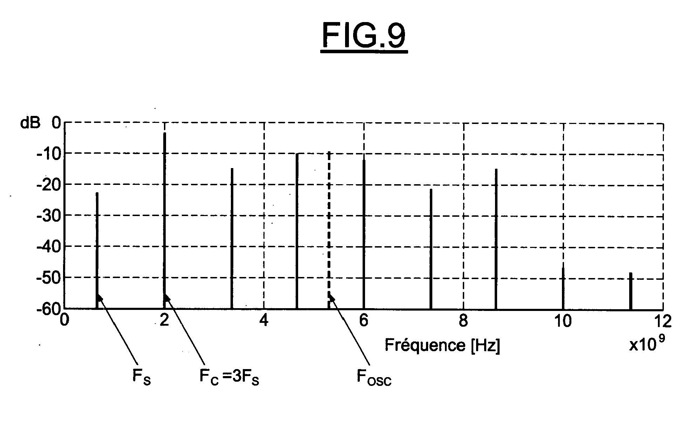

Là encore, comme illustré sur la figure 9, on voit que le troisième harmonique des signaux I_{RF} et Q_{RF} dont la fréquence est égale à la fréquence désirée F_{c}, est prépondérant alors que l'harmonique de rang 1, de fréquence égale à Fₛ est déjà quasiment éliminé. Par ailleurs, la fréquence de l'oscillateur de la boucle à verrouillage de phase F_{osc} se situe entre le septième et le neuvième harmoniques de la fréquence Fₛ.

Il convient de noter que normalement, la génération de signaux orthogonaux qui utilise à la fois les fronts montants et descendants d'un signal d'horloge (ici le signal de base) conduit à un désappariement en phase et en amplitude des deux signaux orthogonaux lorsque le facteur de forme du signal d'horloge est différent de 50 %, ce qui conduit à une dégradation de la qualité de modulation. Or, ce n'est pas le cas lorsque l'on utilise une division fréquentielle rationnelle non entière conforme à un aspect de l'invention. En d'autres termes, les signaux I_{RF} et Q_{RF} obtenus restent orthogonaux (en quadrature de phase) même si le facteur de forme (« duty cycle » en langue anglaise) est différent de 50 %.

Outre la source de pulling principale qui vient d'être supprimée, il peut exister une source additionnelle de pulling provoquant des harmoniques pairs de Fₛ et qui résultent de sommes parasites liées à des injections de courant dans l'alimentation ou dans la masse.

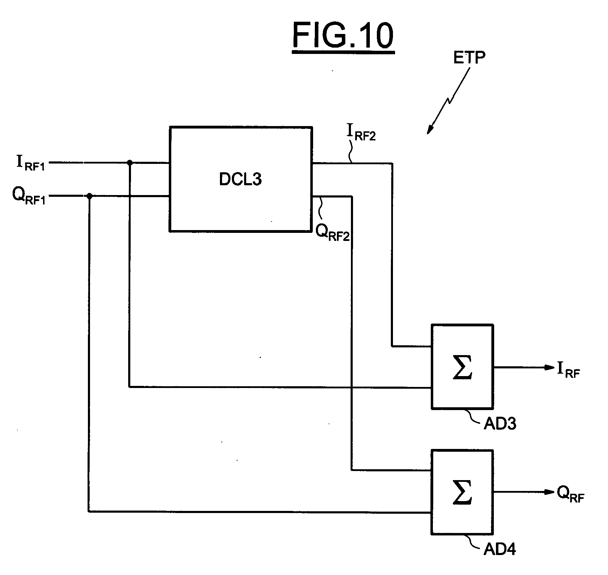

Pour résoudre ce problème additionnel, l'invention prévoit, selon un autre aspect, que les moyens de traitement MTR comportent en outre un étage de post-traitement ETP dont un exemple de réalisation est illustré sur la figure 10.

Plus précisément, si les signaux I_{RF1} et Q_{RF1} sont des signaux prétraités issus du bloc BLC2 de l'étage de prétraitement, l'étage de post-traitement ETP comporte alors un moyen supplémentaire de décalage DCL3 apte à effectuer un décalage de ces deux signaux de la période ou de la demi période du signal de base de façon à obtenir un premier signal prétraité décalé I_{RF2} et un deuxième signal prétraité décalé Q_{RF2} en quadrature de phase par rapport au signal I_{RF2}.

Un additionneur AD3 effectue la somme des signaux I_{RF1} et I_{RF2} pour délivrer le signal de sortie I_{RF} (signal de transposition).

Par ailleurs, un autre additionneur AD4 effectue la somme du signal Q_{RF1} et du signal Q_{RF2} de façon à délivrer l'autre signal de sortie Q_{RF} (signal de transposition) en quadrature de phase par rapport au signal I_{RF}.

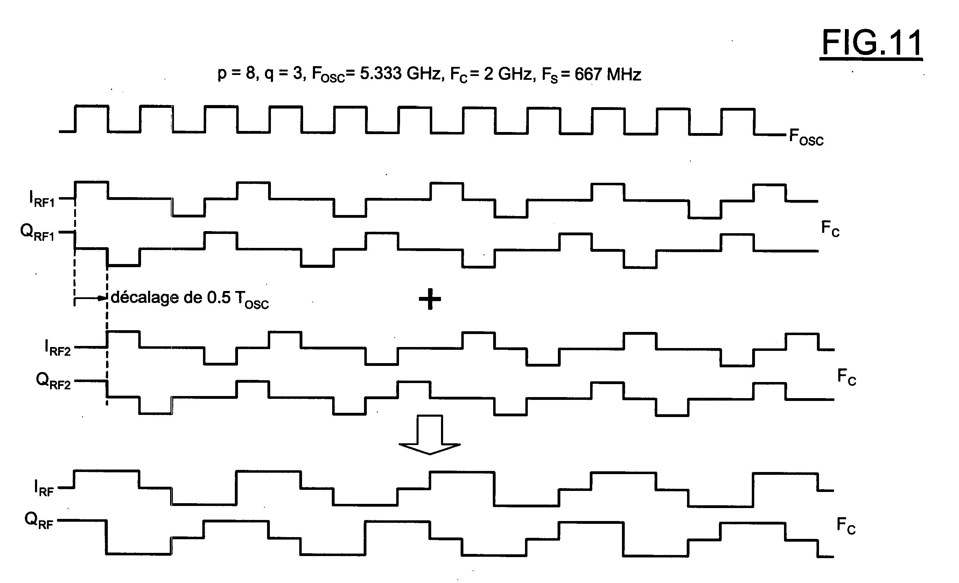

Le fonctionnement de cet étage de post-traitement ETP est illustré sur la figure 11 dans le cas où p est égal à 8 et q est égal à 3 et dans le cas où l'on utilise à la fois les fronts montants et descendants du signal de base de fréquence F_{osc}. On décale alors les signaux I_{RF2} et Q_{RF2} d'une demi période T_{osc} par rapport aux signaux I_{RF1} et Q_{RF1}.

Dans le cas où l'on aurait utilisé que les fronts montants du signal de base, on aurait pu procéder à un décalage d'une période T_{osc}.

De ce fait, on élimine les harmoniques pairs dus à la somme parasite et qui coïncideraient avec la fréquence F_{osc}.

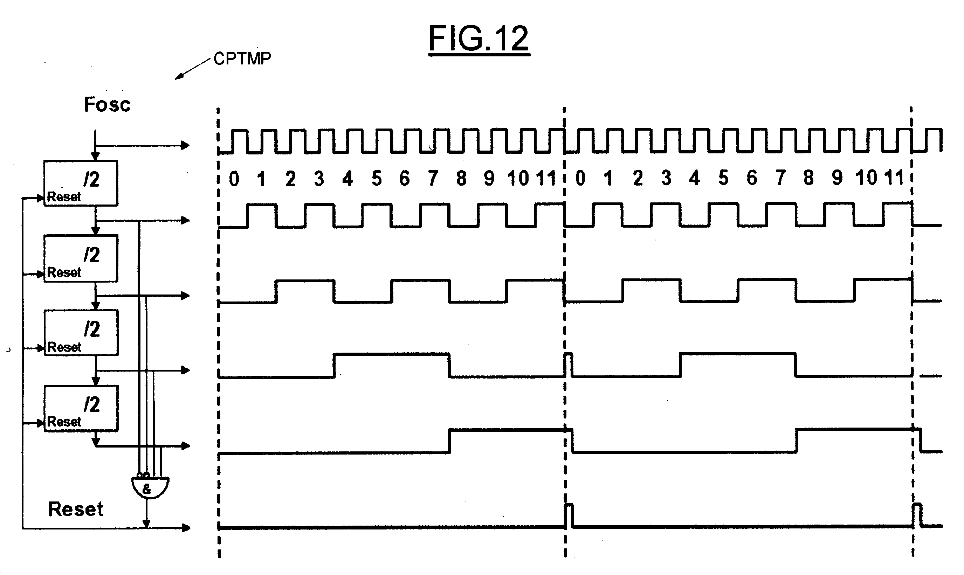

On va maintenant décrire en se référant plus particulièrement aux figures 12 et suivantes, d'autres modes de réalisation et de mise en oeuvre de l'invention.

Lorsque p est une puissance de 2, on utilise avantageusement une succession de diviseurs fréquentiels par 2 DV2, comme illustré sur la figure 2.

Par contre, plus généralement, et en particulier lorsque p n'est pas une puissance de 2, par exemple lorsque p est égal à 12, on utilisera un compteur modulo p CPTMP dont un exemple de réalisation dans le cas où p est égal à 12 est illustré sur la figure 12.

Sur la partie gauche de la figure 12 est illustrée schématiquement la structure interne du compteur CPTMP tandis que sur la partie droite de la figure 12 sont illustrés les signaux d'entrée, de sortie et de remise à zéro (signal référencé Reset) du compteur.

Plus précisément, le compteur modulo p CPTMP comporte quatre diviseurs par 2 possédant chacun une entrée de remise à zéro, et une porte ET avec dans le cas présent deux entrées inverseuses. Cette porte ET détecte quand le compteur arrive au code 12 (1,1,0,0) et génère le signal de remise à zéro Reset qui remet les diviseurs à zéro.

Les quatre sorties des quatre diviseurs par 2 du compteur CPTMP sont alors connectées aux portes AND1-AND4 de la figure 2 de la même façon que sont connectées les sorties des diviseurs DV2 de cette figure 2.

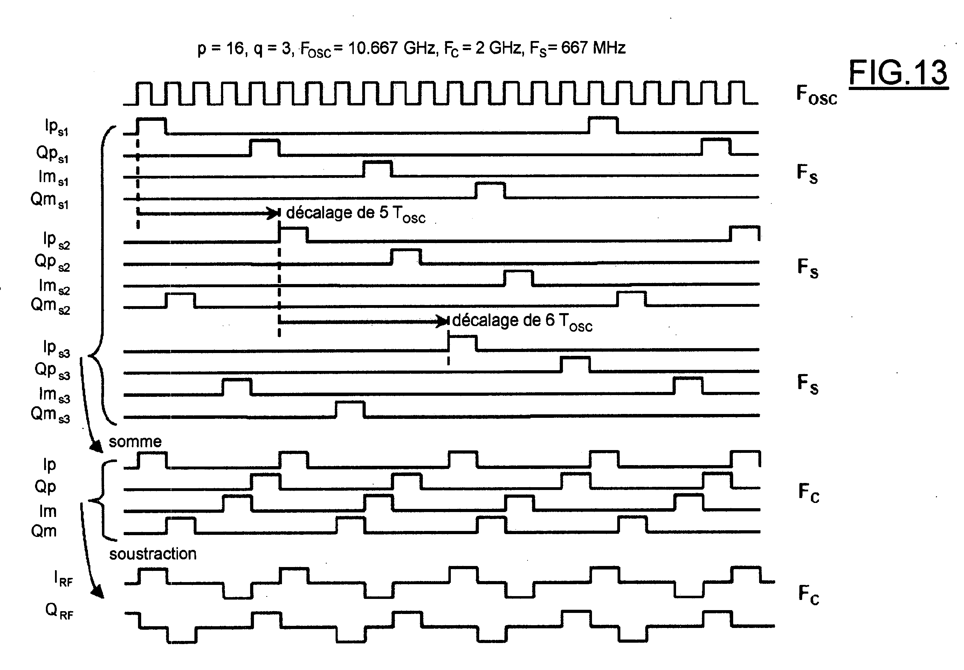

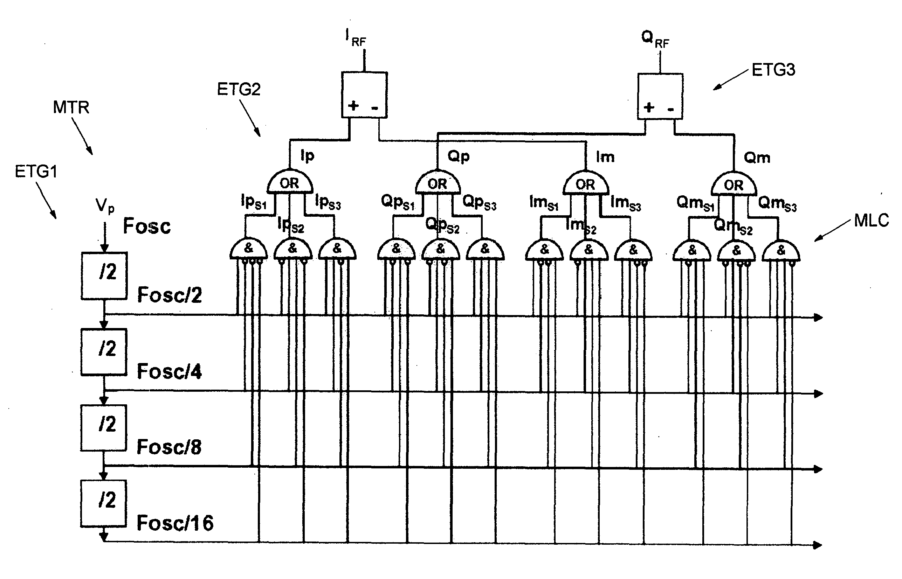

Alors que dans le mode de réalisation illustré sur les figures 2 à 4 en particulier, on effectue une phase de division fréquentielle par p avec élimination des harmoniques pairs suivie d'une multiplication fréquentielle par q, il est également possible d'effectuer, comme illustré plus particulièrement sur les figures 13 et 14, une phase de division fréquentielle par p, la phase de multiplication fréquentielle par q, et la phase d'élimination des harmoniques pairs des signaux issus de la multiplication fréquentielle.

Et, comme on va le voir maintenant, la phase de division fréquentielle et la phase de multiplication fréquentielle comportent avantageusement des opérations communes effectuées en même temps et incluant des combinaisons logiques de signaux et q-1 décalages de signaux par des multiples de la période ou de la demi période du signal de base, chaque multiple de ladite période ou de ladite demi période étant égal au produit de ladite période ou de ladite demi période par un coefficient entier pris dans le groupe des entiers les plus proches de R.

Ainsi, dans le cas illustré sur la figure 13, les deux coefficients entiers sont respectivement égaux à 5 et à 6 (R = 16/3), comme dans le cas de la figure 4.

Plus précisément, comme illustré sur la figure 14, les moyens de traitement MTR comprennent
- un premier sous-étage ETG1 possédant une entrée pour recevoir le signal de base Vp et apte à effectuer la phase de division fréquentielle par p,
- un deuxième sous-étage ETG2 apte à effectuer la phase de multiplication fréquentielle par q, et
- un troisième sous-étage ETG3 apte à effectuer la phase d'élimination des harmoniques pairs issus des signaux du deuxième sous-étage.

Dans l'exemple de la figure 14, le premier sous-étage ETG1 comprend une succession de diviseurs fréquentiels par 2. En variante, cette succession de diviseurs par 2 pourrait être remplacée par un compteur modulo p tel que celui illustré sur la figure 12.

Le premier sous-étage ETG1 et le deuxième sous-étage ETG2 comprennent des moyens logiques communs MLC comportant des portes logiques ET avec certaines de leurs entrées inverseuses.

Plus précisément, les moyens logiques communs comportent ici par exemple deux paires de groupes de q(3) portes logiques ET et sont aptes à générer deux paires de groupes de q signaux ayant chacun une fréquence Fₛ égale à F_{c}/q.

Dans l'exemple illustré sur les figures 13 et 14, le premier groupe de signal d'une première paire comporte un signal périodique secondaire Ipₛ₁ et les deux signaux décalés Ipₛ₂ et Ipₛ₃ par rapport au signal Ipₛ₁. L'autre groupe de trois signaux de ladite paire comporte le signal périodique secondaire Imₛ₁ et les deux signaux décalés Imₛ₂ et Imₛ₃.

On remarque que les signaux Ipₛᵢ et Imₛᵢ sont en opposition de phase.

L'autre paire de groupes de trois signaux comporte :
- le groupe des trois signaux Qpₛ₁, Qpₛ₂ et Qpₛ₃ et,
- le groupe des trois signaux Qmₛ₁, Qmₛ₂ et Qmₛ₃.

Là encore, les signaux Qpₛᵢ et Qmₛᵢ sont en opposition de phase.

Par contre, les signaus Ipₛᵢ et Qpₛᵢ sont en quadrature de phase, de même que les signaux Imₛᵢ et Qmₛᵢ.

Le deuxième sous-étage ETG2 comporte deux paires de portes logiques OU, référencées OR sur la figure 14 respectivement connectées aux deux paires de groupes de portes logiques ET.

Ces portes logiques OU forment des moyens de sommation.

La première paire de portes logiques OU délivre une première paire de signaux périodiques tertiaires Ip et Im.

La deuxième paire de portes logiques OU délivre une autre paire de signaux périodiques tertiaires Qp et Qm.

Chacun de ces signaux périodiques tertiaires a la fréquence Fc.

Puis, le troisième sous-étage ETG3 effectue l'élimination des harmoniques pairs des signaux périodiques tertiaires issus du deuxième sous-étage ETG2.

Ce troisième sous-étage ETG3 est formé de deux soustracteurs respectivement connectés aux deux paires de portes OU.

Le premier soustracteur délivre le signai de transposition I_{RF} et l'autre soustracteur délivre l'autre signal de transposition Q_{RF}.

L'avantage d'un tel mode de réalisation est que la génération des signaux et de leurs images « décalées » est accomplie en une seule étape par des portes ET, tandis que les sommes sont générées par des portes OU et qu'un circuit analogique exécute la soustraction. En conséquence, à l'exception de la soustraction, toutes les opérations sont exécutées par des portes logiques, ce qui est parfaitement et aisément compatible avec une réalisation en technologie numérique.

Une autre façon de réaliser la phase de division fréquentielle par p consiste à utiliser un compteur en anneau, ou compteur Johnson, utilisant des bascules D commandées par des fronts d'horloge.

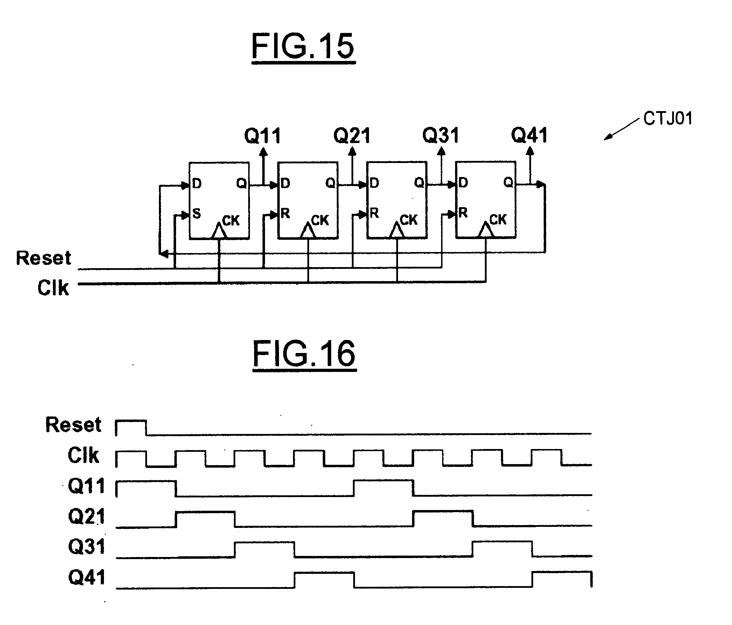

Un exemple de réalisation d'un compteur Johnson CTJO1 à quatre étages est illustré sur la figure 15 et permet d'effectuer une division fréquentielle par 4. Le signal Clk est dans l'application envisagée ici le signal de base Vp, c'est-à-dire le signal de sortie de l'oscillateur commandé en tension.

La figure 16 illustre les différents signaux d'entrée et de sortie du compteur Johnson CTJO1.

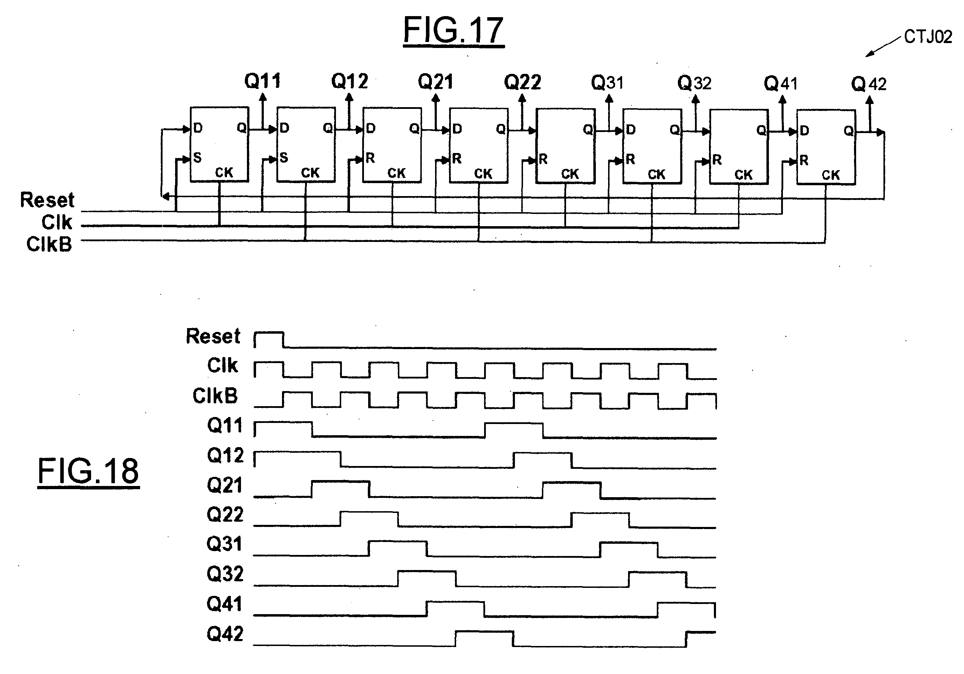

Une autre variante d'un compteur Johnson permettant également d'effectuer par exemple une division par 4 est illustrée sur la figure 17.

Le compteur Johnson CTJ02 comporte ici non pas quatre étages mais huit demi étages, ce qui permet d'avoir des signaux décalés d'une demi période du signal d'horloge Clk, c'est-à-dire du signal de base Vp.

Par ailleurs, le signal ClkB est le signal complémentaire du signal d'horloge Clk.

La figure 18 illustre la forme des signaux mis en oeuvre dans ce compteur Johnson CTJ02 à huit demi étages.

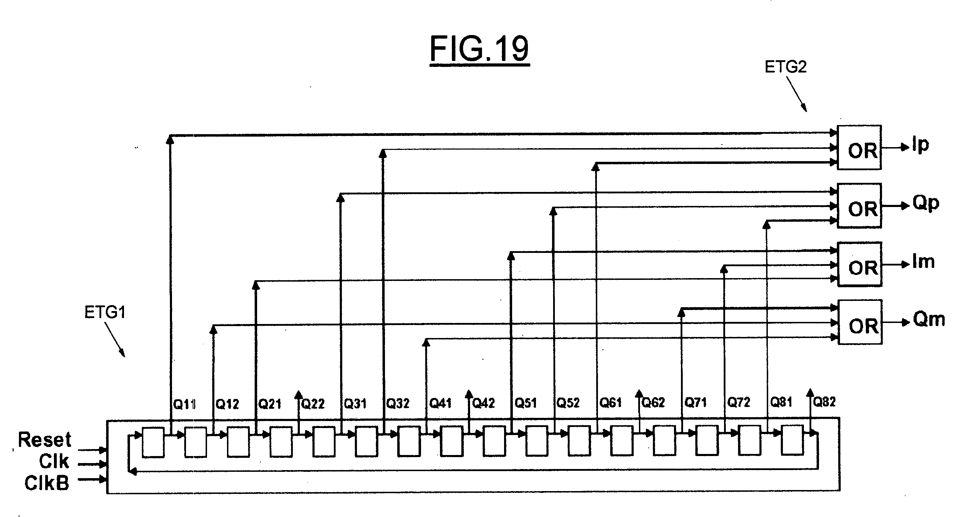

La figure 19 illustre un autre mode de réalisation de l'invention dans lequel, cette fois-ci, le premier sous-étage ETG1 et le deuxième sous-étage ETG2 comportent des moyens logiques communs aptes à effectuer à la fois la division fréquentielle par p et les q-1 décalages de signaux. Ces moyens logiques communs sont formés dans cet exemple par un compteur en anneau (compteur Johnson) à p étages ou 2p demi étages.

Ainsi, dans l'exemple illustré sur la figure 19, utilisé pour effectuer une division par 8 et une multiplication par 3, le compteur CTJO3 est un compteur Johnson à huit étages ou seize demi étages recevant comme signaux de commande le signal Clk, c'est-à-dire le signal de base issu de l'oscillateur local, et le signal complémentaire ClkB.

Le deuxième sous-étage ETG2 comporte, outre le compteur Johnson CTJO3 en tant que moyen commun avec le premier sous-étage ETG1, les quatre portes logiques OU, référencées OR, possédant ici trois entrées chacune et reliées aux différentes sorties des étages ou demi étages du compteur Johnson CTJO3.

Les portes logiques OU délivrent les signaux Ip, Qp, Im et Qm.

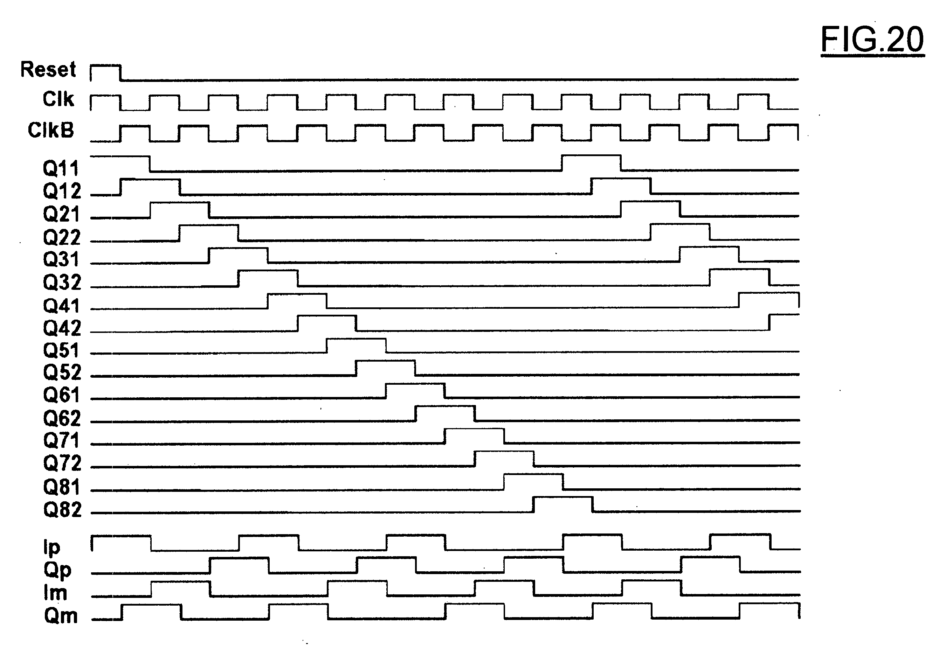

La forme de ces signaux est illustrée sur la figure 20.

Par rapport au mode de réalisation illustré sur la figure 14, cette structure permet de fonctionner à des fréquences plus hautes. Par ailleurs, le chemin entre l'entrée (signaux Clk et ClkB) et les sorties (signaux Ip, Qp, Im et Qm) est plus court. Par conséquent, il y a moins de bruits de phase rajoutés aux signaux délivrés en sortie.

Bien entendu, les signaux Ip, Qp, Im et Qm sont ensuite délivrés à l'étage ETG3, tel que par exemple celui illustré sur la figure 14, et qui effectue une soustraction de signaux de façon à débarrasser les signaux des harmoniques pairs.

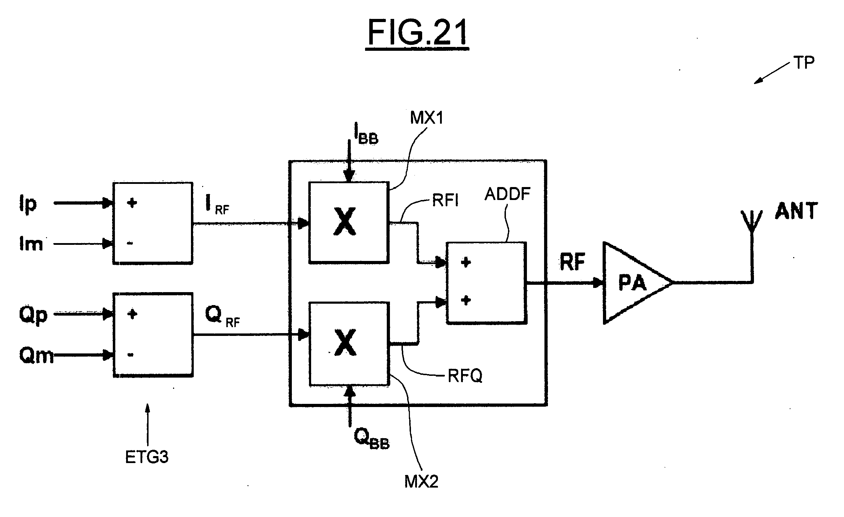

Comme illustré sur la figure 21, et par analogie avec la figure 1, une première solution architecturale utilisable par exemple dans un téléphone mobile cellulaire, consiste à effectuer la transposition de fréquence avec des signaux de transposition issus de l'étage ETG3 et donc déjà débarrassés des harmoniques pairs.

Plus précisément, les signaux de transposition I_{RF} et Q_{RF} sont respectivement délivrés aux mélangeurs MX1 et MX2 qui reçoivent par ailleurs les signaux en bande de base I_{BB} et Q_{BB} et délivrent les deux signaux de sortie RFI et RFQ qui ont un harmonique prépondérant à ia fréquence Fc.

Ces deux signaux RFI et RFQ sont ensuite additionnés dans un additionneur ADDF avant d'être transmis en tant que signal radiofréquence RF à l'amplificateur de sortie PA du téléphone TP.

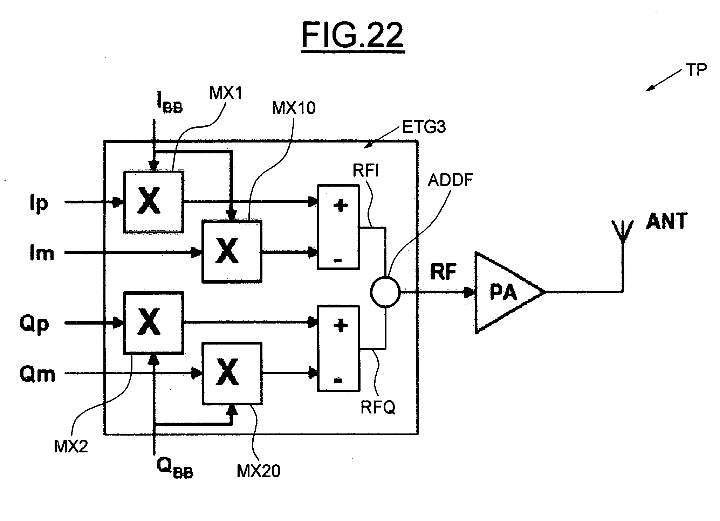

Une autre solution, telle que celle illustrée sur la figure 22, consiste à effectuer d'abord la transposition de fréquence avant la phase d'élimination des harmoniques pairs.

Plus précisément, les signaux Ip, Im sont respectivement délivrés en tant que signaux de transposition à des mélangeurs MX1 et MX10 qui reçoivent tous deux le signal en bande de base I_{BB}.

Par ailleurs, les signaux Qp et Qm sont quant à eux respectivement délivrés à deux mélangeurs MX2 et MX20 en tant que signaux de transposition de fréquence, ces deux mélangeurs MX2 et MX20 recevant par ailleurs l'autre composante Q_{BB} du signal en bande de base.

Les signaux transposés issus des mélangeurs MX1 et MX10 sont ensuite soustraits mutuellement dans un premier soustracteur de l'étage ETG3 de façon à délivrer le premier signal de sortie RFI.

Les deux autres signaux transposés issus des mélangeurs MX2 et MX20 sont également mutuellement soustraits dans le deuxième soustracteur du sous-étage ETG3 de façon à délivrer l'autre signal de sortie RFQ.

Les deux signaux de sortie RFI et RFQ sont ensuite additionnés dans l'additionneur ADDF afin de fournir le signal résultant RF à l'amplificateur de puissance PA du TP.

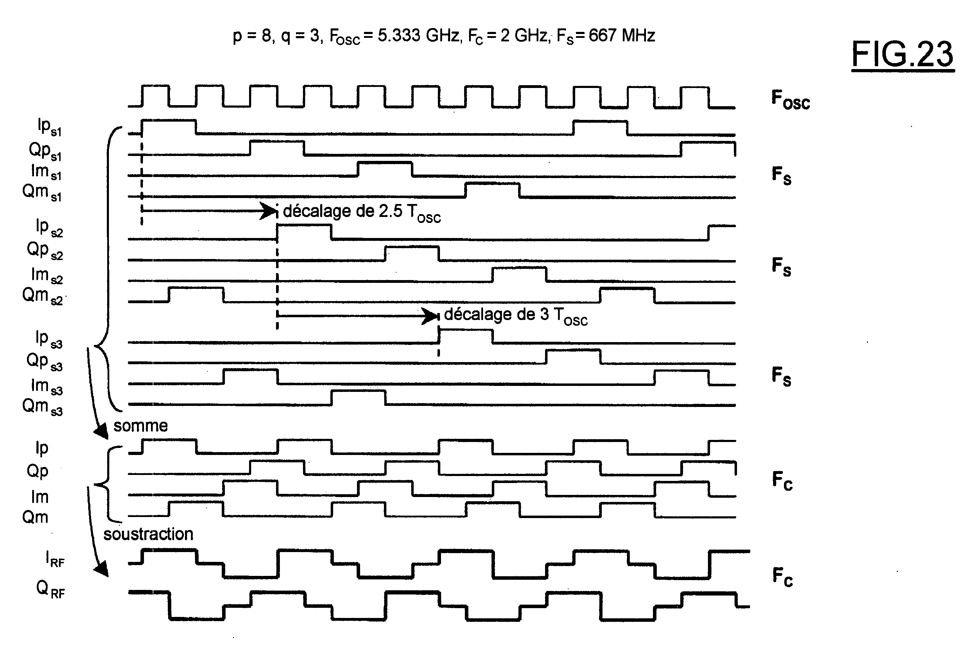

Alors que dans le mode de réalisation illustré sur les figures 10 et 11, on élimine la source additionnelle de pulling en utilisant un étage de post-traitement ETP qui effectue un décalage supplémentaire de signal puis une sommation, on peut, comme illustré sur la figure 23 pour p=8, q=3, F_{osc}=5,333 GHz, éliminer cette source additionnelle de pulling en doublant la largeur des impulsions des signaux Ipₛ₁, Qpₛ₁, Imₛ₁ et Qmₛ₁ par rapport à la largeur des impulsions de ces mêmes signaux tels qu'illustrés sur la figure 8.

Puis, on effectue les décalages, la sommation puis la soustraction et l'on voit que l'on obtient des signaux I_{RF} et Q_{RF} analogues aux signaux I_{RF} et Q_{RF} de la figure 11.

Matériellement, le compteur Johnson tel que le compteur CTJO3 de la figure 19 permet déjà de générer des impulsions avec la bonne largeur. En conséquence, on retrouve là encore, après recombinaison, sommation et soustraction, les signaux I_{RF} et Q_{RF} analogues à ceux de la figure 23.

L'invention a ainsi permis notamment d'éliminer la source prépondérante de pulling dans une chaîne de transmission à conversion directe par l'utilisation d'un diviseur de fréquence rationnel non entier permettant la génération de signaux de transposition orthogonaux de telle sorte que le signal modulé ne présente pas d'harmoniques qui coïncident avec la fréquence de l'oscillateur commandé en tension de la boucle à verrouillage de phase.

Par ailleurs, un choix approprié de la largeur d'impulsion des signaux orthogonaux de transmission permet également d'éliminer les autres sources potentielles de pulling dues en particulier aux chemins parasites du circuit.

En outre, l'utilisation d'un diviseur de fréquence rationnel rend la génération des signaux de transposition insensible au facteur de forme du signal de base (signal de l'oscillateur local de la boucle à verrouillage de phase).

Enfin, une boucle à verrouillage de phase de fréquence raisonnable peut être utilisée, ce qui permet de réduire la consommation de courant.

## Revendications

1. Procédé d'élaboration de deux signaux de sortie (I_{RF}, Q_{RF}) en quadrature de phase ayant un spectre fréquentiel comportant un harmonique prépondérant à une fréquence désirée F_{c}, comprenant la génération d'un signal de base périodique (Vₚ) ayant une fréquence F_{osc} égale au produit de R par ladite fréquence désirée F_{c}, R étant un nombre rationnel non entier supérieur à un et égal à un rapport p/q, où p est un entier multiple de 4 et q un entier impair, une réception de deux signaux initiaux en bande de base en quadrature de phase et un traitement comportant au moins une phase de division fréquentielle par p du signal de base, une phase de multiplication fréquentielle par q, une phase d'élimination d'harmoniques pairs, et une transposition de fréquence des deux signaux initiaux avec des signaux de transposition issus de l'une de ces phases et ayant un spectre fréquentiel comportant un harmonique prépondérant à ladite fréquence désirée F_{c}.

2. Procédé selon la revendication 1, dans lequel le traitement comprend la phase de division fréquentielle par p, la phase de multiplication fréquentielle par q, la phase d'élimination des harmoniques pairs des signaux issus de la multiplication fréquentielle, et la transposition de fréquence avec des signaux de transposition issus de la phase d'élimination et ne comportant que des harmoniques impairs.

3. Procédé selon la revendication 1, dans lequel le traitement comprend la phase de division fréquentielle par p, la phase de multiplication fréquentielle par q, la transposition de fréquence avec des signaux de transposition issus de la phase de multiplication fréquentielle, et l'élimination des harmoniques pairs des signaux transposés.

4. Procédé selon la revendication 2 ou 3, dans lequel la phase de division fréquentielle et la phase de multiplication fréquentielle comportent des opérations communes effectuées en même temps et incluant des combinaisons logiques de signaux et q-1 décalages de signaux par des multiples de la période ou de la demi période du signal de base, chaque multiple de ladite période ou de ladite demi période étant égal au produit de ladite période ou de ladite demi période par un coefficient entier pris dans le groupe des entiers les plus proches de R ou de 2R, respectivement.

5. Procédé selon la revendication 4, dans lequel la phase de division fréquentielle comporte une succession de divisions fréquentielles par 2 (DV2) ou un comptage modulo p du signal de base de façon à générer une succession de signaux primaires, et lesdites opérations communes comportent des combinaisons logiques de ces signaux primaires entre eux et éventuellement avec le signal de base.

6. Procédé selon la revendication 2 ou 3, dans lequel la phase de division fréquentielle et la phase de multiplication fréquentielle comportent des opérations communes effectuées en même temps et incluant la division fréquentielle par p et q-1 décalages de signaux par des multiples de la période ou de la demi période du signal de base, chaque multiple de ladite période ou de ladite demi période étant égal au produit de ladite période ou de ladite demi période par un coefficient entier pris dans le groupe des entiers les plus proches de R ou de 2R, respectivement.

7. Procédé selon l'une des revendications 4 à 6, dans lequel la phase de multiplication comporte en outre une sommation de signaux effectuée après la phase de décalage de façon à délivrer deux paires de signaux périodiques tertiaires ayant chacun la fréquence F_{c}.

8. Procédé selon l'une des revendications 4 à 7, dans lequel lesdites opérations communes comportent une génération de deux paires de groupes de q signaux ayant chacun une fréquence Fₛ égale à F_{c}/q, chaque groupe comportant un signal périodique secondaire et les q-1 signaux décalés par rapport à ce signal périodique secondaire par lesdits multiples de ia période ou de ia demi période du signal de base, les q signaux d'un groupe de chaque paire étant respectivement en opposition de phase par rapport aux q signaux homologues de l'autre groupe de ladite paire, et en quadrature de phase par rapport aux q signaux du groupe homologue de l'autre paire.

9. Procédé selon l'une des revendications 2 à 8, dans lequel la phase d'élimination des harmoniques pairs comporte deux soustractions de signaux de façon à délivrer une paire de signaux.

10. Procédé selon l'une des revendications précédentes, dans lequel la phase de division fréquentielle comporte la délivrance de signaux ayant des impulsions de largeur égale au doublé de la demi-période ou de la période du signal de base.

11. Procédé selon la revendication 1, dans lequel ledit traitement comprend une phase de division fréquentielle par p avec élimination des harmoniques pairs de façon à générer deux signaux intermédiaires périodiques en quadrature de phase (Iₛ₁, Qₛ₁) ayant chacun une fréquence Fₛ égale à F_{c}/q et des harmoniques de fréquences impairs, une phase de multiplication fréquentielle par q des deux signaux intermédiaires, et la transposition de fréquence avec des signaux de transposition issus de la phase de multiplication et ne comportant que des harmoniques impairs.

12. Procédé selon la revendication 11, dans lequel ladite phase de division fréquentielle par p avec élimination des harmoniques pairs comprend
des divisions fréquentielles successives par 2 ou bien un comptage modulo p du signal de base de façon à générer des signaux primaires,
des combinaisons logiques de ces signaux primaires entre eux et éventuellement avec le signal de base de façon à générer deux paires de signaux périodiques secondaires ayant chacun la fréquence Fₛ, (Ipₛ₁, Qpₛ₁, Imₛ₁, Qmₛ₁), les deux signaux secondaires de chaque paire étant en quadrature de phase et les deux paires étant également elles-mêmes en quadrature de phase, et
des soustractions de ces signaux secondaires de façon à générer les deux signaux intermédiaires.

13. Procédé selon la revendication 11 ou 12, dans lequel la paire de signaux intermédiaires comporte un premier signal intermédiaire et un deuxième signal intermédiaire en quadrature de phase par rapport au premier, et dans lequel ladite multiplication fréquentielle par q comporte
q-1 décalages successifs de la paire de signaux intermédiaires par des multiples de la période ou de la demi période du signal de base de façon à obtenir q-1 paires de signaux décalés, chaque paire de signaux décalés comportant premier un signal décalé et un deuxième signal décalé en quadrature de phase par rapport au premier, chaque multiple de ladite période ou de ladite demi période étant égal au produit de ladite période ou de ladite demi période par un coefficient entier pris dans le groupe des entiers les plus proches de R ou de 2R, respectivement,
la somme du premier signal intermédiaire (Iₛ₁) et des q-1 premiers signaux décalés, (Iₛ₂, Iₛ₃)_{,} et
la somme du deuxième signal intermédiaire (Qₛ₁) et des q-1 deuxièmes signaux décalés (Qₛ₂, Qₛ₃).

14. Procédé selon l'une des revendications 11 à 13, dans lequel on effectue la transposition de fréquence avec les signaux directement issus de la multiplication.

15. Procédé selon l'une des revendications 11 à 13, dans lequel la phase de multiplication fréquentielle délivre un premier signal prétraité (I_{RF1}) et un deuxième signal prétraité (Q_{RF1}) en quadrature de phase par rapport au premier signal prétraité, et dans lequel ledit traitement comporte en outre un post-traitement des deux signaux prétraités comportant
un décalage de ces deux signaux prétraités de la période ou de la demi période du signal de base de façon à obtenir un premier signal prétraité décalé (I_{RF2}) et un deuxième signal prétraité décalé (Q_{RF2}) en quadrature de phase par rapport au premier signal prétraité décalé,
la somme du premier signal prétraité et du premier signal prétraité décalé et la somme du deuxième signal prétraité et du deuxième signal prétraité décalé, de façon à obtenir les deux signaux de transposition (I_{RF}, Q_{RF}).

16. Procédé selon l'une des revendications précédentes, dans lequel q est égal à trois.

17. Dispositif d'élaboration de deux signaux de sortie en quadrature de phase ayant un spectre fréquentiel comportant un harmonique prépondérant à une fréquence désirée F_{c}, comprenant des moyens de génération (PLL) aptes à générer un signal de base périodique ayant une fréquence F_{osc} égale au produit de R par ladite fréquence désirée F_{c}, R étant un nombre rationnel non entier supérieur à un et égal à un rapport p/q, où p est un entier multiple de 4 et q un entier impair, une interface d'entrée pour recevoir deux signaux initiaux en bande de base en quadrature de phase, et des moyens de traitement (MTR) connectés aux moyens de génération et à ladite interface d'entrée et aptes à effectuer un traitement comportant au moins une phase de division fréquentielle par p du signal de base, une phase de multiplication fréquentielle par q, une phase d'élimination des harmoniques pairs, et une transposition de fréquence des deux signaux initiaux avec des signaux de transposition issus de l'une de ces phases et ayant un spectre fréquentiel comportant un harmonique prépondérant ladite fréquence désirée F_{c}.

18. Dispositif selon la revendication 17, dans lequel les moyens de traitement incluent un premier sous-étage possédant une entrée pour recevoir le signal de base et apte à effectuer la phase de division fréquentielle par p, un deuxième sous-étage apte à effectuer la phase de multiplication fréquentielle par q, un troisième sous-étage apte à effectuer la phase d'élimination des harmoniques pairs des signaux issus du deuxième sous-étage, et des moyens de transposition de fréquence connectés à ladite interface d'entrée et à la sortie du troisième sous-étage et aptes à délivrer les deux signaux de sortie.

19. Dispositif selon la revendication 18, dans lequel le troisième sous-étage est apte à effectuer des soustractions des signaux délivrés par le deuxième sous-étage.

20. Dispositif selon la revendication 17, dans lequel les moyens de traitement incluent un premier sous-étage apte à effectuer la phase de division fréquentielle par p, un deuxième sous-étage apte à effectuer la phase de multiplication fréquentielle par q, des moyens de transposition de fréquence connectés à ladite interface d'entrée et à la sortie du deuxième sous-étage, et un troisième sous-étage apte à effectuer la phase d'élimination des harmoniques pairs des signaux issus des moyens de transposition de façon à délivrer les deux signaux de sortie.

21. Dispositif selon la revendication 20, dans lequel le troisième sous-étage est apte à effectuer des soustractions des signaux délivrés par les moyens de transposition de fréquence de façon à générer les deux signaux de sortie.

22. Dispositif selon l'une des revendications 18 à 21, dans lequel le premier sous-étage et le deuxième sous-étage comportent des moyens logiques communs aptes à effectuer à la fois des combinaisons logiques de signaux et q-1 décalages de signaux par des multiples de la période ou de la demi période du signal de base, chaque multiple de ladite période ou de ladite demi période étant égal au produit de ladite période ou de ladite demi période par un coefficient entier pris dans le groupe des entiers les plus proches de R ou de 2R, respectivement.

23. Dispositif selon la revendication 22, dans lequel le premier sous-étage comporte une succession de diviseurs fréquentiels par 2 (DV2) ou un compteur modulo p, possédant une entrée pour recevoir le signal de base et des sorties aptes à générer une succession de signaux primaires aux moyens logiques communs, et les moyens logiques communs sont aptes à effectuer des combinaisons logiques de ces signaux primaires entre eux et éventuellement avec le signal de base.

24. Dispositif selon la revendication 23, dans lequel les moyens logiques communs comportent des portes logiques ET avec certaines de leurs entrées inverseuses.

25. Dispositif selon l'une des revendications 18 à 21, dans lequel le premier sous-étage et le deuxième sous-étage comportent des moyens logiques communs aptes à effectuer à la fois la division fréquentielle par p et q-1 décalages de signaux par des multiples de la période ou de la demi période du signal de base, chaque multiple de ladite période ou de ladite demi période étant égal au produit de ladite période ou de ladite demi période par un coefficient entier pris dans le groupe des entiers les plus proches de R ou de 2R, respectivement.

26. Dispositif selon la revendication 25, **caractérisé par le fait que** les moyens logiques communs comportent un compteur en anneau à p étages possédant une entrée pour recevoir le signal de base.

27. Dispositif selon l'une des revendications 18 à 26, dans lequel le deuxième sous-étage comporte des moyens de sommation connectés à la sortie des moyens logiques communs et aptes à délivrer deux paires de signaux périodiques tertiaires ayant chacun la fréquence F_{c}.

28. Dispositif selon la revendication 27 et l'une des revendications 22 à 26, dans lequel les moyens de sommation comportent deux paires de portes logiques OU connectées aux sorties des moyens logiques communs.

29. Dispositif selon l'une des revendications 22 à 28, dans lequel les moyens logiques communs sont aptes à générer deux paires de groupes de q signaux ayant chacun une fréquence Fₛ égale à F_{c}/q, chaque groupe comportant un signal périodique secondaire et les q-1 signaux décalés par rapport à ce signal périodique secondaire par lesdits multiples de la période ou de la demi période du signal de base, les q signaux d'un groupe de chaque paire étant respectivement en opposition de phase par rapport aux q signaux homologues de l'autre groupe de ladite paire, et en quadrature de phase par rapport aux q signaux du groupe homologue de l'autre paire.

30. Dispositif selon les revendications 23 et 29, dans lequel les moyens logiques communs comportent deux paires de groupes de q portes logiques ET avec certaines de leurs entrées inverseuses et sont aptes à générer les deux paires de groupes de q signaux, et les moyens de sommation comportent deux paires de portes logiques OU respectivement connectées aux deux paires de groupes de q portes logiques ET.

31. Dispositif selon les revendications 21 et 30, dans lequel le troisième sous-étage comporte deux soustracteurs respectivement connectés aux deux paires de portes OU.

32. Dispositif selon l'une des revendications 18 à 31, dans lequel le premier étage comporte des moyens aptes à délivrer des signaux ayant des impulsions de largeur égale au double de la demi-période ou de la période du signal de base.

33. Dispositif selon la revendication 32, dans lequel les moyens aptes à délivrer des signaux ayant des impulsions de largeur égale au double de la demi-période ou de la période du signal de base sont constitués du compteur en anneau à p étages.

34. Dispositif selon la revendication 17, dans lequel les moyens de traitement comportent un étage de prétraitement incluant un premier bloc apte à effectuer une division fréquentielle par p avec élimination des harmoniques pairs, un deuxième bloc apte à effectuer une multiplication fréquentielle par q et des moyens de transposition de fréquence connectés à la sortie de l'étage de prétraitement et à ladite interface d'entrée.

35. Dispositif selon la revendication 34, dans lequel le premier bloc (BLC1) est apte à recevoir le signal de base et à délivrer deux signaux intermédiaires périodiques en quadrature de phase ayant chacun une fréquence Fₛ égale à F_{c}/q et des harmoniques de fréquences impairs, et dans lequel le deuxième bloc est apte à effectuer une multiplication fréquentielle par q des deux signaux intermédiaires.

36. Dispositif selon la revendication 35, dans lequel le premier bloc (BLC1) comprend
une succession de diviseurs fréquentiels par 2 (DV2) ou un compteur modulo p, possédant une entrée pour recevoir le signal de base et des sorties aptes à générer une succession de signaux primaires,
une logique (AND1-AND4) apte à effectuer des combinaisons logiques de ces signaux primaires entre eux et éventuellement avec le signal de base de façon à générer deux paires de signaux périodiques secondaires ayant chacun la fréquence Fₛ, les deux signaux secondaires de chaque paire étant en quadrature de phase et les deux paires étant également elles même en quadrature de phase, et
des moyens de soustraction (STR1-STR2) aptes à effectuer des soustractions de ces signaux secondaires de façon à générer les deux signaux intermédiaires.

37. Dispositif selon la revendication 35 ou 36, dans lequel la paire de signaux intermédiaires comporte un premier signal intermédiaire et un deuxième signal intermédiaire en quadrature de phase par rapport au premier, et dans lequel le deuxième bloc (BLC2) comporte
des moyens de décalage (DCL1, DCL2) aptes à effectuer q-1 décalages successifs de la paire de signaux intermédiaires par des multiples de la période ou de la demi période du signal de base de façon à obtenir q-1 paires de signaux décalés, chaque paire de signaux décalés comportant premier un signal décalé et un deuxième signal décalé en quadrature de phase par rapport au premier, chaque multiple de ladite période ou de ladite demi période étant égal au produit de ladite période ou de ladite demi période par un coefficient entier pris dans le groupe des entiers les plus proches de R ou de 2R, respectivement,
un additionneur (AD1) apte à effectuer la somme du premier signal intermédiaire et des q-1 premiers signaux décalés, et
un additionneur (AD2) apte à effectuer la somme du deuxième signal intermédiaire et des q-1 deuxièmes signaux décalés.

38. Dispositif selon l'une des revendications 34 à 37, dans lequel l'étage de prétraitement du signal de base est apte à délivrer un premier signal prétraité et un deuxième signal prétraité en quadrature de phase par rapport au premier signal prétraité, et dans lequel les moyens de traitement comportent en outre un étage de post-traitement (ETP) des deux signaux prétraités, connecté entre la sortie de l'étage de pré-traitement et les moyens de transposition de fréquence et comportant
un moyen supplémentaire de décalage (DCL3) apte à effectuer un décalage de ces deux signaux prétraités de la période ou de la demi période du signal de base de façon à obtenir un premier signal prétraité décalé et un deuxième signal prétraité décalé en quadrature de phase par rapport au premier signal prétraité décalé,
un additionneur (AD3) apte à effectuer la somme du premier signal prétraité et du premier signal prétraité décalé et
un additionneur (AD4) apte à effectuer la somme du deuxième signal prétraité et du deuxième signal prétraité décalé,
de façon à délivrer les deux signaux de transposition.

39. Dispositif selon l'une des revendications 17 à 38, **caractérisé par le fait que** q est égal à trois.

40. Terminal d'un système de communication sans fil, **caractérisé par le fait qu'**il incorpore un dispositif selon l'une des revendications 17 à 39.

41. Terminal selon la revendication 40, **caractérisé par le fait qu'**il forme un téléphone mobile cellulaire.
